# EUROPÄISCHE PATENTSCHRIFT

(11) **EP 3 667 245 B1**
(45) Veröffentlichungstag und Bekanntmachung des Hinweises auf die Patenterteilung: **11.09.2024**
(21) Anmeldenummer: 19213383.3
(22) Anmeldetag: 04.12.2019
(51) Int. Cl.: G01D 4/00, G01D 9/00, G01D 21/00, H04Q 9/00, H04W 4/38, H04W 56/00

(54) **VERFAHREN ZUM SAMMELN VON DATEN, SENSOR SOWIE VERSORGUNGSNETZ**
METHOD FOR COLLECTING DATA, SENSOR AND SUPPLY NETWORK
PROCÉDÉ DE COLLECTE DE DONNÉES, CAPTEUR AINSI QUE RÉSEAU D'ALIMENTATION

(30) Priorität: 14.12.2018 DE 102018009823
(43) Veröffentlichungstag der Anmeldung: 17.06.2020
(73) Patentinhaber: Diehl Metering Systems GmbH, 90451 Nürnberg (DE); DIEHL METERING SAS, 68304 Saint Louis (FR)
(72) Erfinder: Schmitz, Stefan, 90455 Nürnberg (DE); Kauppert, Thomas, 90455 Nürnberg (DE); Joppich-Dohlus, Petra, 91080 Rathsberg (DE); Schmidt, Achim, 91367 Weißenohe (DE); Sosna, Christoph, 90429 Nürnberg (DE); Bach, Guy, 68640 Waldighofen (FR); Breton, Aster, 05350 Saint Véran (FR); Gottschalk, Klaus, 90610 Winkelhaid (DE)
(74) Vertreter: Diehl Patentabteilung

(56) Entgegenhaltungen:
- WO-A1-2018/233865
- US-A1- 2013 285 834
- WALTERS L C: "SHANNON, CODING AND SPREAD SPECTRUM", ELECTRONICS WORLD, NEXUS MEDIA COMMUNICATIONS, SWANLEY, KENT, GB, vol. 95, no. 1638, April 1989 (1989-04-01), pages 375 - 379, XP000032362, ISSN: 0959-8332

## Beschreibung

Die vorliegende Erfindung betrifft zum einen ein Verfahren zum Sammeln von Daten gemäß dem Oberbegriff des Anspruchs 1 sowie zum anderen einen Sensor gemäß dem Oberbegriff des Anspruchs 15 bzw. ein Versorgungsnetz zur Verteilung eines Verbrauchsmediums gemäß dem Oberbegriff des Anspruchs 16.

### Technologischer Hintergrund

Verbrauchszähler sind Bestandteil von Versorgungsnetzen zur Verteilung von Verbrauchsgütern, wie z.B. Gas, Wasser, Wärme oder Elektrizität, und dienen dazu Verbrauchsdaten zu generieren. Verbrauchsdaten werden auf der Basis von von einem Messelement eines Sensors gelieferten Rohmessdaten von einem zählerseitigen Mikroprozessor errechnet und über ein Kommunikationssystem in Form eines BUS-Systems, insbesondere eines sogenannten M-BUS-Systems oder wireless M-BUS-Systems an eine zentrale Datenverwaltung (Head-End-System) weitergeleitet. Bei den Daten handelt es sich vor allem um den aktuellen Verbrauch, d.h. den Zählerstand.

Hierbei werden Rohmessdaten von dem Messelement eines Sensors des Verbrauchszählers zu vorbestimmten vorgegebenen Zeitpunkten generiert, von einem Mikroprozessor des Verbrauchszählers ausgewertet d. h. in Verbrauchsdaten umgerechnet und die daraus resultierenden Verbrauchsdaten anschließend über eine primäre Kommunikationsstrecke von einer Lese- bzw. Empfangseinrichtung (Datensammler bzw. Konzentrator) zu festgelegten Zeitpunkten an den einzelnen lokal angeordneten Verbrauchszähler abgefragt. Anschließend werden die Verbrauchsdaten von der Lese- bzw. Empfangseinrichtung über eine tertiäre Kommunikationsstrecke, beispielsweise auf Basis von LAN, GPRS, 3G, LTE, weiter zu einem Head-End-System übertragen. Die Verbrauchsdaten können dann im Head-End angezeigt oder zur Rechnungsstellung verwendet werden.

Die bisherige Konzeption der Verbrauchsdatenerfassung ist sowohl in ihrer Informationstiefe als auch in ihrem Informationsumfang begrenzt.

### Druckschriftlicher Stand der Technik

Die US 2013/285834 A1 beschreibt ein Verfahren zum Erhalt von genauen, momentanen elektrischen Verbrauchsdaten für Telemetrie Zwecke. Die Daten sollen innerhalb einiger weniger Sekunden mit hoher Auflösung übertragen werden. Pulse werden zusammen mit einem Zeitstempel übertragen, wobei der jeweiligen Puls-bezogene Zeitstempel an dem nachziehenden Ende des jeweiligen Pulses erzeugt wird. Die Übertragung der mit Zeitstempel versehenen Pulse soll permanent in einem fest vorgegebenen Zeitraster von wenigen Sekunden erfolgen.

WALTERS L C: "SHANNON, GODING AND SPREAD SPECTRUM", ELECTRO-NICS WORLD, NEXUS MEDIA COMMUNICATIONS, SWANLEY, KENT, GB, Bd. 95, Nr. 1638, 1. April 1989 (1989-04-01), Seiten 375-379, XP000032362, ISSN: 0959-8332 beschreibt Fehlerkorrekturschemata, um sich einem logarithmischen Austausch anzunähern.

Die nachveröffentlichte WO 2018/233865 A1 offenbart ein Verfahren zum Sammeln von Daten im Bereich der Fernauslesung von Haushaltszählern. Hierbei wird eine redundante Datenübertragung durchgeführt, um auch bei schlechter Funkverbindungsqualität einen zuverlässigen und vollständigen Abruf der Rohmessdaten zu gewährleisten. Bei der beschriebenen redundanten Datenübertragung handelt es sich um eine statische bzw. feste Anzahl an Sendewiederholungen.

### Aufgabe der vorliegenden Erfindung

Die Aufgabe der vorliegenden Erfindung besteht darin, ein gattungsgemäßes Verfahren zum Sammeln und/oder Weiterleiten von Daten, einen hierfür einzusetzenden Sensor sowie ein entsprechendes Versorgungsnetz jeweils mit gesteigertem Informationsinhalt zur Verfügung zu stellen.

### Lösung der Aufgabe

Die vorstehende Aufgabe wird durch die Merkmale des Anspruchs 1 gelöst. Zweckmäßige Ausgestaltungen des erfindungsgemäßen Verfahrens werden in den abhängigen Ansprüchen beansprucht. Erfindungsgemäß werden zur Festlegung der Messauflösung des Sensors die Bedingungen für ein Generieren von Zeitstempelungen unter Anwendung eines Korrelierungsmodells vorher festgelegt. Auf der Basis des Korrelierungsmodells werden Zeitstempelungen von aufeinanderfolgenden Rohmessdaten in dem Sensor generiert und in den Speichermitteln abgelegt. Anschließend werden lediglich die den erfassten Rohmessdaten zugeordneten Zeitstempelungen beispielsweise über eine drahtgebundene Verbindung und/oder über eine Funkstrecke übertragen, so dass auf Basis der Zeitstempelungen unter Anwendung des Korrelierungsmodells die vom Messelement erfassten Rohmessdaten nach erfolgter Übertragung wieder rekonstruiert und ausgewertet werden können. Hierdurch entfallen rechenaufwendige und deshalb energieintensive Rechenoperationen im Bereich des lokalen Sensors. Rechenaufwendige und energieintensive Rechenoperationen können somit in den Bereich eines Datensammlers oder eines Head-Ends verlagert werden. Das erfindungsgemäße Verfahren ermöglicht es, Zeitstempelungen von Rohmessdaten in einem fortlaufenden, vollständigen und konsistenten Zeitzusammenhang also lückenlos im Bereich des Datensammlers, einer Abfrageeinrichtung oder eines Konzentrators bereitzustellen und diese anschließend über eine tertiäre Kommunikationsstrecke dem Head-End zuzuleiten. Die aus den Zeitstempelungen rekonstruierten Rohmessdaten können dem Zeitverlauf kontinuierlich zugeordnet werden, d.h. bilden einen Realzeit-Verlauf ab, der diskontinuierliche Lücken oder Datenfehlzeiten ausschließt. Der gemäß dem erfindungsgemäßen Verfahren im Head-End erzeugte kontinuierliche Rohmessdatenstrom besitzt im Vergleich zu bisherigen Lösungen eine sehr viel höhere Auflösung über der kontinuierlichen Zeitachse. Die Erfindung ermöglicht es, neben z. B. einer Verbrauchsberechnung eine viel größere Anzahl von Berechnungen und/oder Feststellungen und/oder Funktionen einschließlich "Business"-Funktionen im Head-End vornehmen zu können, als dies bisher möglich war. Das erfindungsgemäße Verfahren ermöglicht es darüber hinaus, Zustandsfeststellungen bezüglich eines Versorgungsnetzes vorzunehmen. Hierdurch kann dem Kunden eines Versorgungsnetzes eine wesentlich bessere Transparenz als bisher vom Anbieter geboten werden. Aufgrund des erfindungsgemäßen Verfahrens kann zudem der Aufbau des Sensors wesentlich einfacher und kostengünstiger sein, da komplexe Mikroprozessoren für Berechnungen wegfallen. Aufgrund des erfassten zeitlichen Zusammenhangs der Rohmessdaten können Manipulationen vermieden werden, da die Messergebnisse über deren gesamten zeitlichen Verlauf mit empirischen Werten entlang der gesamten Zeitachse verglichen werden können. Ferner ist der Energieverbrauch der Baugruppe aus Sensor und der Zeitstempelaufbereitung bzw. den Kommunikationsmitteln wegen des Wegfalls von energieintensiver Rechenleistung wesentlich geringer als bei bisherigen Ausführungen, welche die Daten lokal auswerten. Bei den Zeitstempelungen kann es sich um Zeitpunkte oder Zeitdifferenzen handeln. Die Zeitpunkte oder Zeitdifferenzen können Ist-Zeitdaten oder Realzeitdaten sein oder zumindest daran orientiert sein. Die Zeitdifferenzen können von Zeitstempelung zu Zeitstempelung und/oder von einem fest vorgegebenen Zeitpunkt ausgebildet sein.

Diese Art der Auswertung benötigt einen kontinuierlichen, vollständigen und konsistenten Datenstrom aus Zeitstempelungen. Um die Zuverlässigkeit des Datenstroms auch für Funkverbindungen mit schlechter Übertragungsqualität zu gewährleisten, wird die Übertragung der Daten bzw. der Zeitstempelungen mit einer Redundanz durchgeführt, welche dynamisch während des Betriebs anpassbar ist. Eine statische und feste Redundanzrate spiegelt nicht die reale Qualität der Verbindung bzw. der Funkverbindung wider. Die Redundanz verbraucht zusätzliche Ressourcen wie Bandbreite und Batteriestrom. Durch die Anpassung der Redundanz an die Qualität der Verbindung bzw. der Funkverbindung wird der Verbrauch von Ressourcen optimiert. Beispielsweise ist für Sensoren bzw. Verbrauchszähler mit einer guten Verbindungsqualität bzw. Funkverbindungsqualität eine geringere Redundanz notwendig, so dass diese Sensoren bzw. Verbrauchszähler weniger Batteriestrom verbrauchen. Durch die Verwendung einer geringeren Bandbreite wird z. B. die Kanallast reduziert, so dass die Kanalkapazität für Sensoren bzw. Verbrauchszähler mit schlechterer Verbindungsqualität verwendet werden kann. Dadurch kann die Leistung der Verbindung bzw. der Funkverbindung des gesamten Netzwerks optimiert werden. Zudem kann sich die Qualität der Funkübertragung mit der Zeit verändern, so dass die Redundanz an diese Veränderungen angepasst werden kann.

Erfindungsgemäß stehen der oder die lokalen Sensoren über eine primäre Kommunikationsstrecke mit einem Datensammler in Verbindung. Zwischen dem Datensammler und einem Head-End befindetsich eine tertiäre Kommunikationsstrecke. Ferner werden die von Sensoren übertragenen Zeitstempelungen im Datensammler und/oder im Head-End gesammelt, gespeichert und/oder ausgewertet. Die Übertragung der Zeitstempelungen über die primäre und tertiäre Kommunikationsstrecke ermöglicht es, eine erheblich größere Anzahl von Berechnungen und/oder Feststellungen und/oder Funktionen einschließlich "Business"-Funktionen im Head-End, wo genügend Rechenleistung zur Verfügung steht, vornehmen zu können als bisher.

Die Zeitstempelungen können vorzugsweise in komprimierter Form übertragen werden. Dies ermöglicht geradezu das erfindungsgemäße Verfahren. So können durch das erfindungsgemäße Verfahren z.B. äquidistante Zeitstempelungen für ihre Übertragung vereinfacht festgelegt werden.

Die Komprimierung der Zeitstempelungen im Bereich des Sensors kann verlustfrei durchgeführt werden. Alternativ kann die Komprimierung der Zeitstempelungen aber auch mit einem vorgegebenen, zulässigen Verlustniveau durchgeführt werden. Wird die Datenkomprimierung mit einem vorgegebenen zulässigen Verlustniveau durchgeführt, kann, wenn der Benutzer oder Betreiber eine Energieeinsparung bevorzugt und eine gewisse Ungenauigkeit bei der Wiederherstellung und Wiedergabe der ursprünglichen Messdaten akzeptiert (d.h. einen gewissen Verlust akzeptiert), das Komprimierungsverhältnis dann zum Nachteil einer geringeren Genauigkeit bei der Wiedergabe auf der Empfängerseite erhöht werden. Das Verlustverhältnis oder das Komprimierungsverhältnis kann als programmierbarer oder einstellbarer Parameter vorgesehen sein, der den Komprimierungsmodus bestimmt oder einstellt.

Als anschauliche und nicht beschränkende Beispiele für Datenkomprimierungsalgorithmen kann im Rahmen des erfindungsgemäßen Verfahrens in Betracht gezogen werden: eine differenzielle Komprimierung (Delta-Kodierung) in Verbindung mit einer Huffman-Kodierung, eine Lauflängenkodierung (RLE-Kodierung) oder vorzugsweise eine adaptive binäre arithmetische Kodierung (CABAC-Kodierung).

Bei dem Korrelierungsmodell kann ein bestimmter Wert oder eine bestimmte Wertänderung oder eine bestimmte Wertdifferenz der mindestens einen physikalischen oder physikalisch-chemischen Größe oder des mindestens einen physikalischen oder physikalisch-chemischen Parameters für die Zuordnung einer Zeitstempelung festgelegt werden, wobei bei einem Erfassen des bestimmten Werts oder der bestimmten Wertdifferenz oder der bestimmten Wertänderung durch das Messelement die Zeitstempelung ausgelöst, als solche in den Speichermitteln des Sensors abgespeichert und für die Übertragung bereitgestellt wird. Ändert sich der vom Sensor erfasste Wert nicht, wird keine Zeitstempelung erzeugt. Somit können typisch für das erfindungsgemäße Verfahren längere Zeiträume ohne Zeitstempelung verstreichen. Es müssen somit nicht ständig Daten übertragen werden. Dennoch besitzt das Verfahren eine sehr hohe Auflösung.

Insbesondere können im Rahmen des Korrelierungsmodells ein schrittweise oder inkrementell sich erhöhender Zählerstand und/oder eine Wertetabelle mittels Zeitstempelungen abgebildet werden.

Vorzugsweise sind die Zeitstempelungen mit einem Vorzeichen, z.B. Plus- oder Minusvorzeichen, versehen. Dies ist vor allem bei der Abbildung einer Wertetabelle von Vorteil, da hierdurch festgelegt wird, ob die konkrete Zeitstempelung einen aufsteigenden oder absteigenden Wert der Wertetabelle betrifft.

Gemäß der Erfindung werden eine Mehrzahl von Zeitstempelungen entlang der primären Kommunikationsstrecke jeweils als Datenpaket übertragen.

Vorteilhafterweise kann auf Basis der beim Datensammler und/oder beim Head-End ankommenden Zeitstempelungen unter Anwendung des Korrelierungsmodells ein Rohmessdatenstrom generiert werden. Bei den betreffenden aufeinanderfolgenden Zeitstempelungen handelt es sich insbesondere um keine Berechnungen und/oder Auswertungen.

Zweckmäßigerweise besitzt der Rohmessdatenstrom eine zeitliche Auflösung, die nur durch die Sensor-Abtastrate bzw. Messelement-Abtastrate oder ein Vielfaches derselben festgelegt oder zumindest bedingt ist. Die zeitliche Auflösung des Rohmessdatenstroms liegt vorzugsweise im Sekundenbereich, Zehntelsekundenbereich, Hundertstelsekundenbereich oder Tausendstelsekundenbereich.

Vorteilhaft ist der Rohmessdatenstrom unter Zugrundelegung der festgelegten Auflösung kontinuierlich und/oder vollständig. Daraus resultiert eine ganz besonders hohe Messwertauflösung entlang des kontinuierlichen Zeitverlaufs und daraus wiederum eine besondere Informationstiefe als Basis für darauf aufbauende Auswertungen bzw. Berechnungen.

Vorzugsweise ist der Rohmessdatenstrom in der Weiterfolge der Datenverarbeitung abgesehen von seiner zeitlichen Auflösung (Abtastrate oder Vielfaches der Abtastrate) jederzeit auf einer zeithistorischen Basis zeitlückenlos auswertbar. Daraus resultiert der Vorteil, dass z.B. auch in der Vergangenheit liegende ereignisbedingte Zustandsveränderungen im Versorgungsnetzwerk (wie z.B. Overflow, Underflow, Leckagen, Manipulationsversuche usw.) in genauer Zeitzuordnung und ohne Lücken feststellbar bzw. dokumentierbar sind. Ferner besteht die Möglichkeit, vergangene Verbrauchsdaten dem Verbraucher wesentlich genauer anzuzeigen und/oder bei Auswertungen hinsichtlich des Verbrauchsverhaltens bzw. Änderungen desselben besser miteinzubeziehen. Dies wiederum wirkt sich verbrauchsoptimierend aus und stellt für den Verbraucher eine besonders wichtige Information des Netzversorgers dar.

Es besteht ferner die Möglichkeit, dass die gespeicherten Zeitstempelungen in den Speichermitteln des Sensors erst dann gelöscht, wenn die Übertragung der Zeitstempelungen über die primäre Kommunikationsstrecke vom Empfänger bzw. Datensammler bestätigt worden ist.

Um den kontinuierlichen Rohmessdatenstrom zu erzeugen, werden die Daten-Pakete zweckmäßigerweise in einer entsprechenden Zeitabfolge-Referenz zusammengefügt oder zumindest zueinander in Relation gesetzt, sodass die in den Paketen enthaltenen Zeitstempelungen entlang der Realzeitachse entsprechend ihrer Abtastung und vorherigen Paketaufteilung später wieder zusammengefügt oder zumindest in eine fortlaufende zeitliche Relation zueinander gesetzt sind.

Beispielsweise kann es sich bei elementaren Messeinheiten um die elektrische Spannung oder um die Stromstärke handeln, die gemessen werden. Beispielsweise kann die Ausgangsspannung eines Hallsensors im Falle seiner Anregung oder die Spannung eines Temperaturfühlers erfasst werden. Zweckmäßigerweise kann sich die gemessene physikalische Größe auf ein Versorgungsmedium, vorzugsweise Wasser, Strom, Treibstoff oder Gas, eines Versorgungsnetzes beziehen.

Es besteht die Möglichkeit, dass der oder einer der gemessene(n) physikalische(n) oder chemisch-physikalische(n) Parameter kennzeichnend ist für die Menge, die Qualität und/oder Zusammensetzung eines Fluids, das durch den betreffenden Sensor strömt oder von diesem kontaktiert wird.

Die elementare Messeinheit kann zweckmäßigerweise eine Zeitstempelung generieren, sobald die elementare Messeinheit einen Impuls empfängt.

Die Festlegung der Frage, wann eine neue Datenübertragung in Form einer Nachricht oder eines Telegramms (eines oder mehrerer Datenpakete) durchzuführen ist, hängt erfindungsgemäß davon ab, ob mindestens die Bedingung b) der beiden Bedingungen
(a) Ablauf eines vorgegebenen Zeitintervalls und
(b) Erreichen einer vorgegebenen Menge an insbesondere komprimierten gesammelten Zeitstempelungen seit der vorherigen Übertragung erfüllt ist. Aufgrund dessen kann eine Zeitabfolge-Referenz der zu übertragenden Daten-Pakete in einfacher Weise realisiert werden.

Besonders zweckmäßig ist, dass das Verfahren umfasst, die Zeitstempelungen durch Formatierung in Datenpaketen vorbestimmter fester Größe zu verpacken, wobei jedes Mal, wenn die akkumulierten Daten die Größe eines Datenpakets erreichen oder das vorgegebene Zeitintervall abgelaufen ist, eine neue Übertragung ausgelöst wird.

Erfindungsgemäß wird die Redundanz in der Übertragung durch wiederholtes Senden desselben Datenpakets in mehreren aufeinanderfolgenden Übertragungsvorgängen erreicht. Es besteht somit die Möglichkeit, dass die Redundanz in der Übertragung durch wiederholtes Senden derselben Zeitstempelungen erreicht wird. Beispielsweise kann die Übertragung eines Datenpakets oder einer Zeitstempelung fünf Mal wiederholt werden.

Vorteilhafterweise kann die Anzahl der Sende-Wiederholungen durch einen Redundanzfaktor festgelegt werden. Der Wert des Redundanzfaktors kann die Anzahl der Wiederholungen festlegen.

Zweckmäßigerweise kann der Redundanzfaktor dynamisch durch einen Datensammler und/oder ein Head-End festgelegt werden. Es besteht die Möglichkeit, dass der Redundanzfaktor in Abhängigkeit der Qualität der Funkverbindung dynamisch festgelegt wird. Der Datensammler und/oder das Head-End können hierfür die Qualität der Funkverbindung überwachen und analysieren. Für diese Analyse können verschiedene Metriken verwendet werden, wie beispielsweise Frame Loss Ratio (FLR) oder die Signalqualität mittels signal-to-noise ratio (SNR) oder Received Signal Strenth Indicator (RSSI). In Abhängigkeit der Metriken für die Qualität der Funkverbindung wird der Redundanzfaktor angepasst. Beispielsweise werden bei einer Funkverbindung mit einer sehr geringen Verlustrate die Daten bzw. Datenpakete bzw. Zeitstempelungen zwei oder drei Mal wiederholt gesendet. Dagegen wird z. B. bei einer Funkverbindung mit schlechter

Übertragungsqualität die Anzahl der Wiederholungen beispielsweise auf 7 oder 8 erhöht. Da sich die Qualität der Funkverbindung mit der Zeit ändern kann, ist es notwendig, dass eine kontinuierliche Überwachung und Anpassung der Redundanz bzw. des Redundanzfaktors durchgeführt wird. Im Head-End bzw. im Datensammler können Algorithmen, welche auf den Metriken für die Qualität der Funkverbindung basieren, implementiert werden, welche automatisch die Redundanz bzw. den Redundanzfaktor optimieren.

Alternativ oder zusätzlich besteht die Möglichkeit, dass in Abhängigkeit der Anzahl der empfangenen Wiederholungen aufgrund der Redundanz, Eigenschaften oder Parameter der Funkverbindung angepasst werden. Hierfür wird die Redundanz verwendet, um beispielsweise im Head-End Parameter und/oder Einstellungen für die Funkverbindung aktiv zu regeln. Beispielsweise kann für einen Sensor bzw. Verbrauchszähler mit einer großen Menge an redundanten Daten im Head-End dessen Sendeleistung reduziert werden und/oder dessen Übertragungsintervall vergrößert werden und/oder dessen Datenrate erhöht werden. Das Übertragungsintervall kann beispielsweise von 5 Minuten auf 15 Minuten erhöht werden. Durch ein größeres Übertragungsintervall kann der Sensor bzw. der Verbrauchszähler vorteilhafterweise Energie sparen und die Last des gesamten Netzwerks bzw. Funknetzwerks reduziert werden.

Die vorliegende Erfindung betrifft des Weiteren einen Sensor gemäß Anspruch 15, welcher hergerichtet ist für den lokalen Einsatz in einem eine Mehrzahl von lokalen Sensoren sowie einen mit dem oder den lokalen Sensoren über eine primäre Kommunikationsstrecke in Verbindung stehenden Datensammler umfassenden Versorgungsnetz zur Verteilung eines Verbrauchsmediums, wie z.B. Wasser, Gas, Elektrizität, Treibstoff oder Wärme. Ein solcher Sensor kann Bestandteil eines Verbrauchszählers sein. Er ermöglicht es, im Rahmen des Betriebs eines Versorgungsnetzes den Verbrauch sowie weitere Zustandseigenschaften in sehr hoher Auflösung entlang des zeitlichen Verlaufs lückenlos und kontinuierlich zu gewährleisten.

Schließlich betrifft die vorliegende Erfindung auch ein Versorgungsnetz gemäß Anspruch 16 zur Verteilung eines Verbrauchsmediums wie z.B. Gas, Wasser, Elektrizität, Treibstoff oder Wärme mit mindestens einem lokalen Sensor vorzugsweise einer Mehrzahl von lokalen Sensoren zum Generieren und/oder Weiterleiten von Rohmessdaten, vorzugsweise Rohmessdaten in Zusammenhang mit einem Verbrauch an Verbrauchsmedium und/oder einem Betriebszustand eines Verbrauchszählers, mit einem Datensammler, einer primären Kommunikationsstrecke zwischen dem jeweiligen Sensor und dem Datensammler, einem Head-End zur Auswertung der Daten sowie einer tertiären Kommunikationsstrecke zwischen Datensammler und Head-End. Gemäß der vorliegenden Erfindung ist das Versorgungsnetz dadurch gekennzeichnet, dass als Sensor ein Sensor nach Anspruch 15 vorgesehen ist.

### Beschreibung der Erfindung anhand von Ausführungsbeispielen

Nachstehend wird die vorliegende Erfindung anhand verschiedener Ausführungsbeispiele näher erläutert. Es zeigen:
- Fig. 1: eine stark vereinfachte schematische Darstellung eines Beispiels von Kommunikationsstrecken eines Versorgungsnetzes zum Sammeln und/oder Weiterleiten von Daten, die von einer Vielzahl von Verbrauchszählern aufgenommen werden, an einen Datensammler und ein Head-End;
- Fig. 2: eine stark vereinfachte schematische Darstellungsweise eines Beispiels der Übertragung von Zeitstempelungen charakteristischer Rohmessdaten über die primäre Kommunikationsstrecke von Fig. 1 zum Datensammler bzw. Konzentrator;
- Fig. 3: ein Beispiel für eine Nachrichtenstruktur, die von der Messdatenaufbereitung des Verbrauchszählers gemäß Fig. 2 über die primäre Kommunikationsstrecke emittiert bzw. abgefragt wird;
- Fig. 4: ein Beispiel für ein Chronogramm von Zeitstempelungen von den von einem Sensor ausgelesenen Rohmessdaten zwischen zwei Uplink-Übertragungsvorgängen (Nachrichten oder Telegramme, die zu den Zeitpunkten T_{E}-1 und T_{E} emittiert werden), in einem Kontext der Fernablesung des Volumenverbrauchs (in diesem Fall enthält das Paket PAⱼ N Zeitstempelungen TS_{N});
- Fig. 5: ein Beispiel für das Zusammenfügen der die Zeitstempelungen enthaltenen Datenpakete bzw. Nachrichten bzw. Telegramme sowie Rekonstruktionen zu einem zeitkontinuierlichen Rohmessdatenstrom einschließlich dessen Auswertemöglichkeiten in stark vereinfachter schematischer Darstellungsweise;
- Fig. 6: ein Beispiel eines Sensors eines Verbrauchszählers in Form eines mechanischen Durchflusszählers mit einem Flügelrad, mit dem entsprechende Zeitstempelungen von Rohmessdaten für den Durchfluss erzeugt werden können;
- Fig. 7: ein Beispiel eines auf Korrelationsmodells zur Generierung von Zeitstempelungen auf Basis der von dem Sensor gemäß Fig. 6 erfassten Rohmessdaten;
- Fig. 8: ein Beispiel eines Temperatursensors in vereinfachter Darstellung,
- Fig. 9: ein weiteres Beispiel eines Korrelationsmodells zur Generierung von Zeitstempelungen auf Basis der von dem Sensor gemäß Fig. 8 erfassten Rohmessdaten, sowie
- Fig. 10a-c: Beispiele für redundante Übertragungen der PAⱼ-Datenpakete mit unterschiedlichen Redundanzfaktoren.

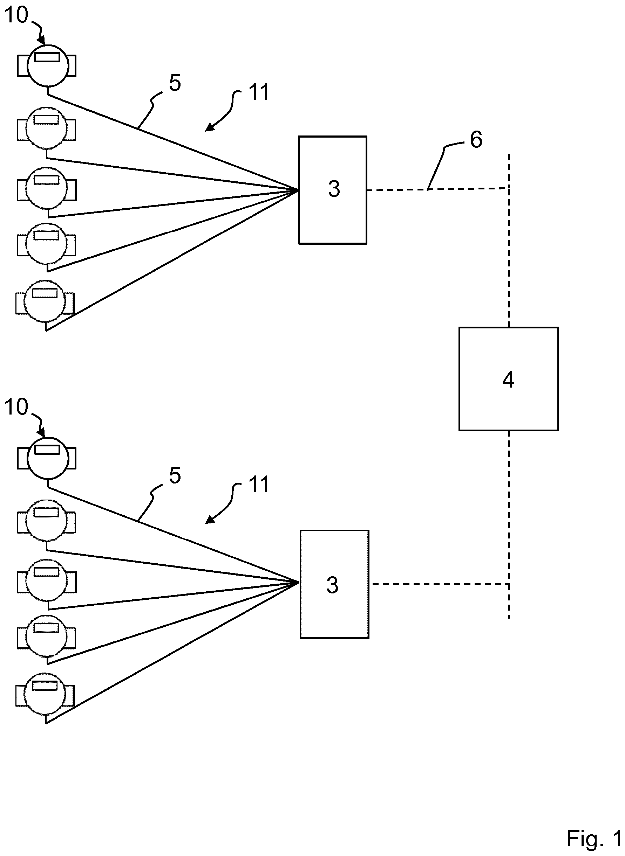

Fig. 1 zeigt ein Versorgungsnetz zur Verteilung von Verbrauchsmedien, wie z.B. Gas, Wasser, Elektrizität, Treibstoff oder Wärme. Das Versorgungsnetz umfasst eine Vielzahl von einzelnen lokalen Verbrauchszählern 10, die z.B. unterschiedlichen Wohneinheiten eines Mehrfamilienhauses zugeordnet sein können. Die einzelnen Verbrauchszähler 10, z.B. Wasserzähler, Wärmezähler, Elektrizitätszähler oder Gaszähler, sind über eine primäre Kommunikationsstrecke 5, wie z. B. eine Funkstrecke, mit einem Datensammler 3, verbunden. Die Datenübertragung von dem jeweiligen Verbrauchszähler 10 über die primäre Kommunikationsstrecke 5 zum Datensammler 3 wird "Uplink-Übertragung" genannt.

Jeder einzelne Verbrauchszähler 10 kann zweckmäßigerweise mit einer zugehörigen ID (Adresse) versehen sein, sodass jeder einzelne Verbrauchszähler 10 vom Datensammler 3 direkt adressiert werden kann und die im jeweiligen Verbrauchszähler 10 vorhandenen Daten abgerufen werden können.

Die Übertragung über die primäre Kommunikationsstrecke 5 wird durch ein BUS-Übertragungsprotokoll vorgegeben, wie z.B. durch das wireless M-BUS-Übertragungsprotokoll.

Der jeweilige Datensammler 3 steht über eine tertiäre Kommunikationsstrecke 6 mit einem sogenannten Head-End 4 in Verbindung. Im Head-End 4 laufen die Daten des gesamten Versorgungsnetzes zusammen. Bei der tertiären Kommunikationsstrecke 6 kann es sich um eine drahtgebundene Kommunikationsstrecke oder um eine auf Funktechnologie basierende Kommunikationsstrecke (z.B. Mobilfunk-Kommunikationsstrecke) handeln. Alternativ können die Daten des jeweiligen Datensammlers 3 bei Bedarf auch von einer portablen Leseeinrichtung ausgelesen und am Head-End 4 wieder eingelesen werden. Die Daten können entlang der tertiären Kommunikationsstrecke 6 auf unterschiedliche Art und Weise übertragen werden, beispielsweise via LAN, GPRS, LTE, 3G, 4G usw.

Unter sekundärer Kommunikationsstrecke wird eine Kommunikationsstrecke zwischen mehreren Datensammlern bzw. Konzentratoren untereinander verstanden, auf die es jedoch vorliegend nicht ankommt.

Die einzelnen Verbrauchszähler 10 können mit einer eigenständigen Energieversorgung (Akku) betrieben werden.

Wie in Fig. 1 schematisch dargestellt, werden die vorzugsweise komprimierten und formatierten Zeitstempelungen TS jedes betreffenden Sensors 1 bzw. Verbrauchszählers 10 an den Datensammler 3, der ein lokales Netzwerk einer Vielzahl von ihm zugeordneten Verbrauchszählern 10 bzw. Sensoren 1 verwaltet, übertragen. Von dem Datensammler 3 werden die vorzugsweise komprimierten und formatierten Zeitstempelungen TS jedes der Sensoren 1, die Teil des Versorgungsnetzes sind, an das Head-End 4 übertragen.

Der Datensammler 3 kann die von den jeweiligen Sensoren 1 bzw. Verbrauchszählern 10 abgerufenen Zeitstempelungen TS entweder über ein Zeitintervall (z.B. einen Tag) speichern und dann an einen Verarbeitungsstandort bzw. an das Head-End 4 weiterleiten. Alternativ können die Daten vom Datensammler 3 auch sofort an das Head-End 4 weitergeleitet werden.

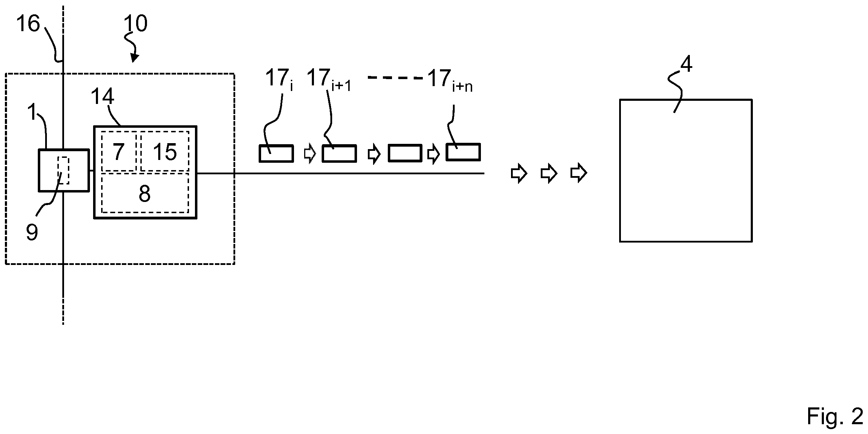

Gemäß Fig. 2 umfasst der jeweilige Verbrauchszähler 10 einen mit mindestens einem Messelement 9 ausgestatteten Sensor 1. Der Sensor 1 ist dazu vorgesehen, über das Messelement 9 Rohmessdaten zu erzeugen, die einer Messdatenaufbereitung 14 zugeführt werden. In der Messdatenaufbereitung 14 erfolgt eine Zeitstempelung aufgrund der Rohmessdaten. Die Rohmessdaten entsprechen vom Messelement 9 gelieferten elementaren Messeinheiten der mindestens einen physikalischen oder physikalisch-chemischen Größe oder des mindestens einen physikalischen oder physikalisch-chemischen Parameters. Bei den Rohmessdaten kann es sich beispielsweise um Rohdaten in Zusammenhang mit dem Durchfluss eines Mediums durch eine Versorgungsleitung 16, z.B. Wasserleitung, handeln, insbesondere die Durchflussmenge, die Trübung, das Vorhandensein von Schadstoffen oder das Vorhandensein eines festen und/oder gasförmigen Anteils bzw. fester und/oder gasförmiger Anteile.

Die Messwertaufbereitung 14 des Verbrauchszählers 10 umfasst Speichermittel 7, eine Zeitreferenzeinrichtung 15 (Quarz) sowie einen Mikroprozessor 8. Die vorgenannten Komponenten können getrennt oder als integrierte Gesamtkomponente vorgesehen sein. Der Verbrauchszähler 10 kann eine (nicht dargestellte) eigene Stromversorgung in Form einer Batterie oder dergleichen bei Bedarf umfassen. Somit kann der Verbrauchszähler 10 energieautark betrieben werden.

Im Vorfeld zu den in Fig. 2 dargestellten Schritten werden im Rahmen des Korrelierungsmodells ein bestimmter Wert, eine bestimmte Wertänderung oder eine bestimmte Wertdifferenz der mindestens einen physikalischen oder physikalisch-chemischen Größe oder des mindestens einen physikalischen oder physikalisch-chemischen Parameters für die Zuordnung einer Zeitstempelung TS festgelegt.

Wie in Fig. 2 dargestellt, erfolgen im Bereich des jeweiligen Verbrauchszählers 10 erfindungsgemäß folgende Schritte:
- Auslösen einer Zeitstempelung TS bei einem Erfassen des bestimmten Werts, der bestimmten Wertänderung oder der bestimmten Wertdifferenz durch das Messelement (9).
- Abspeichern der Zeitstempelungen TS in den Speichermitteln 7 des Sensors 1 bzw. des Verbrauchszählers 10.
- Übertragen der Zeitstempelungen TS in komprimierter Form über eine Funkstrecke 11, indem in der Messdatenaufbereitung 14 Zeitstempelung-Telegramme 17ᵢ, 17ᵢ₊₁, 17ᵢ₊ₙ vorbereitet werden, die sukzessive an eine zentrale Verarbeitungsanlage, wie z.B. ein Head-End 4, übertragen werden. Die Kompression (Komprimierung) der Zeitstempelungen TS für die Übertragung nimmt der Mikroprozessor 8 vor.

Dementsprechend werden zeitlich nacheinander Datentelegramme 17ᵢ, 17ᵢ₊₁, ...., 17ᵢ₊ₙ übertragen, die fortlaufende Zeitstempelungen TS enthalten. Aus diesen Zeitstempelungen TS kann empfängerseitig unter Anwendung des Korrelierungsmodells ein kontinuierlicher lückenloser Rohmessdatenstrom von sehr hoher Auflösung rekonstruiert werden.

Die vorzugsweise komprimierten Zeitstempelungen TS werden beispielsweise über ein Messdaten-Informationsnetzwerk übertragen, welches eine primäre Kommunikationsstrecke 5 in Form einer Funkstrecke 11 zu einem Datensammler 3 aufweist. Der Datensammler 3 ist wiederum über eine tertiäre Kommunikationsstrecke 6 mit dem Head-End 4 verbunden. Die Daten können entlang der tertiären Kommunikationsstrecke 6 auf unterschiedliche Art und Weise übertragen werden, beispielsweise via LAN, GPRS, LTE, 3G usw.

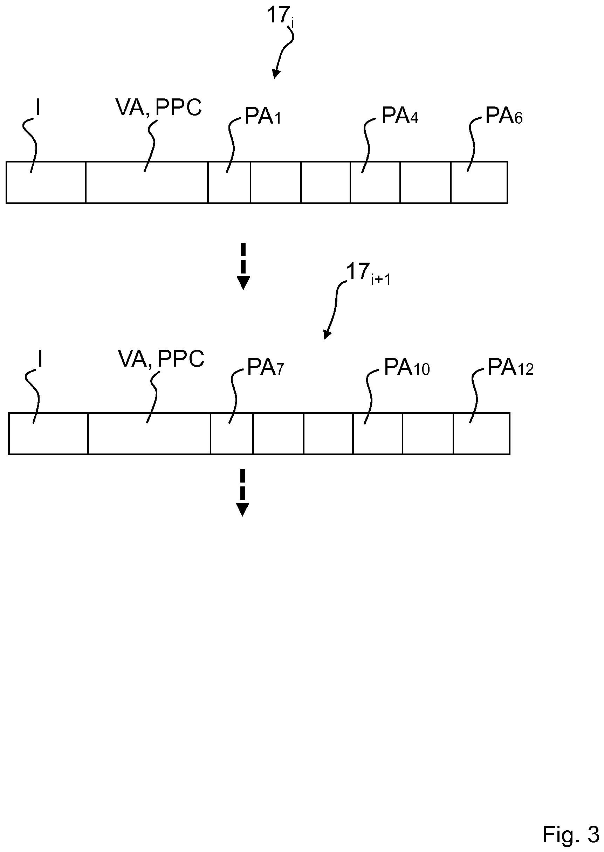

Fig. 3 zeigt beispielhaft die einzelnen Datentelegramme 17ᵢ, 17ᵢ₊₁, ...., 17ᵢ₊ₙ gemäß Fig. 2 etwas detaillierter. Die Datentelegramme 17ᵢ, 17ᵢ₊₁, ...., 17ᵢ₊ₙ umfassen jeweils zum einen eine Mehrzahl von Datenpaketen PA₁-PA₆ bzw. PA₇-PA₁₂, den absoluten oder kumulierten Wert VA, die Identität (Adresse) I des betreffenden Sensors 1 sowie den Wert mindestens eines anderen physikalischen oder physikalisch-chemischen Parameters PPC der Umgebung des betreffenden Sensors 1 oder des von letzterem zu einem bestimmten Zeitpunkt gemessenen Fluids, wie z.B. die Leitfähigkeit des Fluids, die Temperatur des Fluids, den pH-Wert des Fluids, den Druck des Fluids, einen Parameter, der für die Qualität und/oder die Zusammensetzung des Fluids und/oder die Temperatur der Einbauumgebung des Sensors 1 kennzeichnend ist.

Wie in Fig. 3 weiterhin als Beispiel dargestellt ist, kann vorgesehen sein, die komprimierten Zeitstempelungen TS durch Formatierung der PAⱼ-Pakete, deren Größe einen vorgegebenen Maximalwert nicht überschreiten darf, zu verpacken, wobei jedes Mal, wenn die akkumulierten Daten die Größe eines Pakets PAⱼ erreichen, ein neues Paket bzw. Telegramm gebildet wird bzw. eine neue Übertragung ausgelöst wird, sofern das vorgegebene Zeitintervall nicht vorher abgelaufen ist.

Gemäß einer bevorzugten Variante der Erfindung werden die Zeitstempelungen TS vor deren Übertragung komprimiert. Die Komprimierung der Zeitstempelungen TS kann verlustfrei durchgeführt werden.

Alternativ kann die Komprimierung der Zeitstempelungen TS auch mit einem vorgegebenen zulässigen Verlustniveau durchgeführt werden. In der Tat kann, wenn der Benutzer oder Betreiber eine Energieeinsparung bevorzugt und eine gewisse Ungenauigkeit bei der Wiederherstellung und Wiedergabe der ursprünglichen Rohmessdaten akzeptiert (d. h. einen gewissen Verlust akzeptiert), das Komprimierungsverhältnis dann zum Nachteil einer geringeren Genauigkeit bei der Wiedergabe auf der Empfangsseite erhöht werden. Dieses Verlustverhältnis oder das Komprimierungsverhältnis kann als programmierbarer oder einstellbarer Parameter vorgesehen werden, der den Komprimierungsmodus bestimmt oder einstellt.

Als anschauliche und nicht beschränkende Beispiele für Datenkomprimierungsalgorithmen kann im Rahmen des erfindungsgemäßen Verfahrens in Betracht gezogen werden, eine differentielle Kodierung (Delta-Kodierung) in Verbindung mit einer Huffman-Kodierung, eine Lauflängenkodierung (RLE-Kodierung) oder vorzugsweise eine adaptive binäre arithmetische Kodierung (CABAC-Kodierung) anzuwenden.

Es besteht die Möglichkeit, dass die Zeitstempelungen TS in den Speichermitteln 7 des Verbrauchszählers 10 erst dann gelöscht werden, wenn die Übertragung der Zeitstempelungen TS vom Empfänger bzw. Datensammler 3 bestätigt worden ist.

Dank der Erfindung ist es möglich, am Datensammler 3 bzw. Empfangsort (z. B. Head-End 4) über Informationen zu verfügen, die eine originalgetreue und vollständige Rekonstruktion aller Daten von den verschiedenen Sensoren 1 anhand der gelieferten Zeitstempelungen TS in sehr hoher zeitlicher Auflösung ermöglichen und eine unbegrenzte Flexibilität bei der Auswertung dieser Daten zulassen. So kann man einfach und zentral die Erweiterungsfähigkeit von "Business"-Funktionen berücksichtigen, ohne die Funktionsweise oder gar den Aufbau von Baugruppen (Sensoren, Kommunikationsmittel, und dergleichen) zu beeinflussen.

Der Aufbau des Sensors 1 kann im Vergleich zu bisher bekannten Lösungen einfacher und sein Betrieb sicherer sein. Ferner ist der Energieverbrauch der Baugruppe aus dem Sensor 1 und den Kommunikationsmitteln 2 geringer als bei den aktuellen Ausführungen, welche die Daten lokal auswerten.

Die Erfindung kann auf die Messung und Fernauslesung verschiedenster Parameter und Größen angewendet werden. Es genügt, eine elementare (vom Sensor 1 messbare) Veränderung eines Parameters oder einer Größe in Übereinstimmung mit der Auflösung des betrachteten Sensors 1 genau datieren zu können (die Zeitstempelung TS kann der Auflösung des Sensors 1 oder möglicherweise einem Vielfachen dieser Auflösung entsprechen).

Wenn sich die gemessene Größe oder der gemessene Parameter auch dekrementell ändern kann, sind die Zeitstempel TS mit Vorzeichen versehene elementare Maßeinheiten (positive oder negative Einheiten).

Im Zusammenhang mit einer vorteilhaften Anwendung der Erfindung, verbunden mit dem Begriff des Verbrauchs, kann vorgesehen sein, dass die oder eine der gemessenen physikalischen Größe(n) sich auf ein Strömungsmedium bezieht, wobei jede Zeitstempelung TS einer elementaren Fluidmenge entspricht, die durch den Sensor 1, abhängig von seiner Messgenauigkeit, gemessen wird. Das gemessene Fluid kann beispielsweise Gas, Wasser, Kraftstoff oder eine chemische Substanz sein.

Alternativ oder kumulativ zu der oben genannten Ausführungsvariante kann die Erfindung auch vorsehen, dass die oder eine der gemessene(n) physikalisch-chemische(n) Größe(n) ausgewählt ist aus der Gruppe, die gebildet wird durch die Temperatur, den pH-Wert, die Leitfähigkeit und den Druck eines durch den betreffenden Sensor 1 hindurchströmenden oder von diesem kontaktierten Fluids.

Wenn alternativ oder kumulativ mindestens ein Parameter gemessen wird, kann dieser oder einer dieser gemessene(n) physikalische(n) oder physikalisch-chemische(n) Parameter kennzeichnend sein für die Qualität und/oder Zusammensetzung eines Fluids, das den betreffenden Sensor 1 durchströmt oder mit ihm in Kontakt kommt, wie z. B. Trübung, das Vorhandensein von Schadstoffen oder das Vorhandensein eines festen und/oder gasförmigen Anteils bzw. fester und/oder gasförmiger Anteile.

Die oben genannten Größen und Parameter sind selbstverständlich nur Beispiele, die nicht beschränkend sind.

Dementsprechend werden fortlaufend Datentelegramme 17 zu einem bestimmten Zeitpunkt gebildet und sukzessive übertragen. Die einzelnen Datenpakete PA₁, ..., PAₙ bilden im Anschluss daran in ihrer Summe einen fortlaufenden zeitgestempelten Rohmessdatenstrom 13.

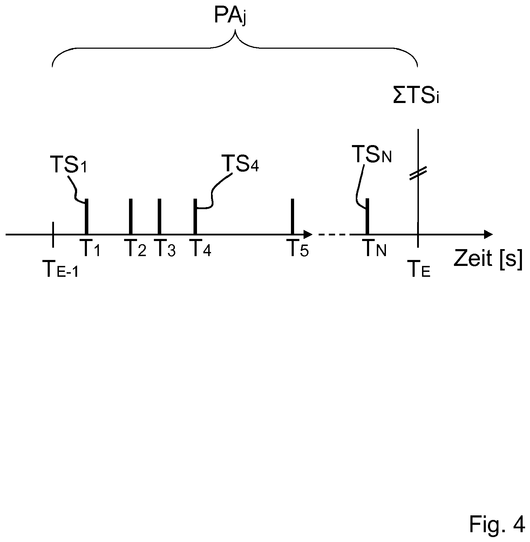

Fig. 4 zeigt exemplarisch ein Beispiel für eine Nachrichtenstruktur, die vom Sensor 1 bzw. Verbrauchszähler 10 an den Datensammler 3 bzw. an das Head-End 4 übertragen wird. Jede Zeitstempelung TS, bis TS_{N} entspricht hierbei im Rahmen des Korrelierungsmodells einer elementaren Fluidmenge, die durch den Sensor 1 gemessen wird. Das gemessene Fluid kann beispielsweise Gas, Wasser, Kraftstoff oder eine chemische Substanz sein. In dem Zeitintervall T_{E-1} bis T_{E} werden so N Impulse gemessen und die Zeitstempelungen TS₁ bis TS_{N} gespeichert, was bei einer Menge von z. B. einem Liter pro Zeitstempelung TS einer Durchflussmenge von insgesamt N Liter innerhalb dieses Zeitintervalls entspricht. Die Messwertaufbereitung bildet ein Datenpaket PAⱼ, welches N Zeitstempelungen TS₁ bis TS_{N} enthält. Aus der Mehrzahl von Datenpaketen z. B. PA₁ bis PA₆ bzw. PA₇ bis PA₁₂ werden gemäß Fig. 3 Datentelegramme 17ᵢ, 17ᵢ₊₁ gebildet.

Damit sich das erfindungsgemäße Verfahren an Veränderungen in der Entwicklung des Parameters oder der Messgröße anpassen kann und gleichzeitig eine zufriedenstellende Aktualisierung der verfügbaren Momentandaten gewährleistet ist, kann das Verfahren vorteilhafterweise insbesondere darin bestehen, ein neues Paket bzw. Telegramm 17 zu bilden bzw. eine neue Datenübertragung in Form einer Nachricht oder eines Telegramms durchzuführen, sobald mindestens die nachfolgende Bedingung b) erfüllt ist:
(a) Ein vorgegebenes Zeitintervall ist abgelaufen und
(b) eine vorgegebene Menge an insbesondere komprimierten gesammelten Daten bzw. Zeitstempelungen TS seit der vorherigen Übertragung ist erreicht.

Die Anwendung der genannten Bedingung (b) kann beispielsweise darin bestehen, nachdem eine vorgegebene Anzahl neuer Zeitstempelungen TS erstellt wurde, regelmäßig die Größe aller neuen Zeitstempelungen TS in komprimierter oder verdichteter Form zu überprüfen.

Wenn diese Größen nahe einer kritischen Größe liegen, beispielsweise nahe der Größe eines durch das Übertragungsprotokoll festgelegten Pakets, wird ein neuer Übertragungsvorgang durchgeführt (Bedingung (b) vor Bedingung (a) verifiziert), es sei denn, die vordefinierte Grenzzahl zwischen zwei aufeinanderfolgenden Übertragungen wurde zuerst erreicht (Bedingung (a) vor Bedingung (b) verifiziert).

Wie in Figur 3 beispielhaft dargestellt, kann zudem vorgesehen sein, zusammen mit den PAⱼ-Paketen der der Zeitstempelungen TS auch die Identität (Adresse) I des betreffenden Sensors 1 und/oder den absoluten oder kumulierten Wert VA der bzw. des vom betreffenden Sensor 1 gemessenen physikalischen oder physikalisch-chemischen Größe oder Parameters in dem jeweiligen Datentelegramm 17ᵢ, 17ᵢ₊₁, ...., 17ᵢ₊ₙ zu übertragen, wobei der Wert VA mit einem Zeitstempel versehen oder einem der elementaren zeitgestempelten Messdaten, beispielsweise einem Indexwert eines Fluidzählers zugeordnet sein kann. Der Wert VA kann - gemäß Ausführungsbeispiel - z. B. der Zählerstand eines Verbrauchszählers 10, insbesondere eines Wasserzählers zu einem bestimmten Zeitpunkt oder die Durchflussmenge durch den Wasserzähler seit einer vorherigen Datenübertragung (z. B. entspricht die Summe der Zeitstempelungen ΣTSᵢ der Summe Σ der Durchflussmenge; siehe Figur 4) sein.

Das Verfahren kann auch darin bestehen, mit den PAⱼ -Paketen von Zeitstempelungen TS den Wert mindestens eines anderen physikalischen oder physikalisch-chemischen Parameters PPC der Umgebung des betreffenden Sensors 1 oder des von diesem letzteren gemessenen Fluids zu einem bestimmten Zeitpunkt auszulesen und zu übertragen, wie beispielsweise die Leitfähigkeit des Fluids, die Temperatur des Fluids, den pH-Wert des Fluids, den Druck des Fluids, und/oder einen Parameter, der für die Qualität und/oder die Zusammensetzung des Fluids und/oder die Temperatur der Einbauumgebung des Sensors 1 kennzeichnend ist.

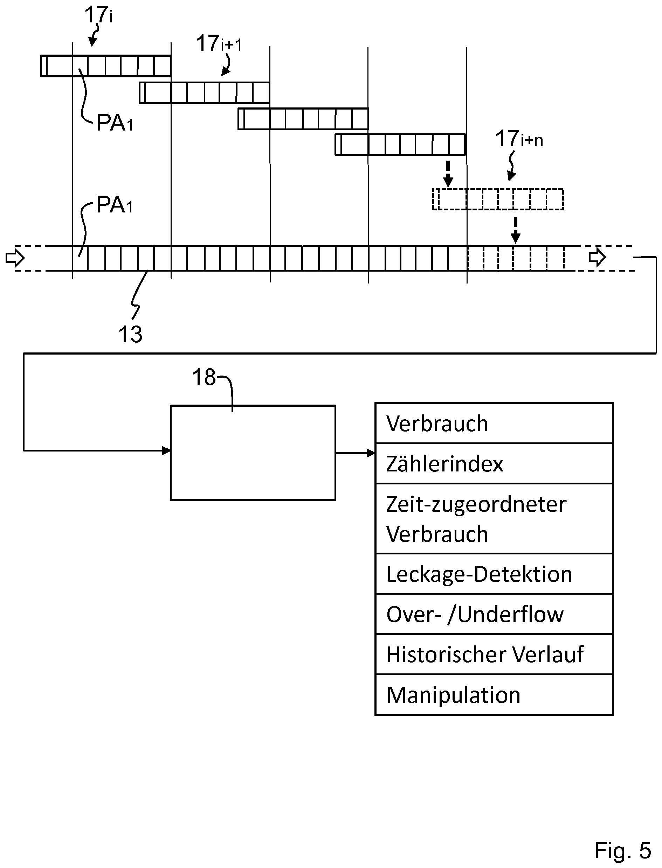

Fig. 5 zeigt die Weiterverarbeitung der einzelnen in Datentelegrammen 17ᵢ bis 17ᵢ₊ₙ bereitgestellten Zeitstempelungen TS zu einer fortlaufenden zusammenhängenden Zuordnung, aus der anhand des Korrelierungsmodells ein lückenloser Rohmessdatenstrom 13 rekonstruiert werden kann. Hierbei werden die einzelnen Datentelegramme 17ᵢ bis 17ᵢ₊ₙ so zusammengefügt, dass die jeweiligen Daten bzw. Datenpakete (PAⱼ) bzw. die darin enthaltenen Zeitstempelungen TS in Zeitrelation mit denen der benachbarten Datenpakete PAⱼ gebracht werden.

Durch die erfindungsgemäße Sammlung von Zeitstempelungen TS, die von den Sensoren 1 des oder eines bestimmten Netzwerks geliefert werden, ermöglicht die Erfindung alle Arten von Auswertung, Analyse, Überprüfung, Überwachung sowie allgemein nützlicher oder gewünschter Verarbeitung und Verwertung, da die grundlegende einzelne Rohinformation zur Verfügung steht. Die Auswertung der bereitgestellten Zeitstempelungen TS erfolgt vorzugsweise im Bereich des Head-Ends 4 über Auswertemittel 18 und ergibt eine Vielzahl wichtiger Informationen, die für die Verwaltung des Versorgungsnetzes notwendig sind, bisher aber noch nicht generiert werden konnten, wie z.B. Verbrauch, Zählerindex, zeitzugeordneter Verbrauch, Leckage-Detektion, Over-/Underflow, historischer Verlauf und/oder Manipulation. Informationen können somit jederzeit auch retrospektive zeitlückenlos abgerufen und einer bisherigen Auswertung zugeführt werden.

Die aus den Zeitstempelungen TS rekonstruierten Rohmessdaten liegen im Head-End 4 erfindungsgemäß als Rohmessdatenstrom 13 in sehr hoher Auflösung (Granularität) ohne zeitliche Lücken vor. Demzufolge liegen im Gegensatz zu bisherigen Verfahren aufgrund des erfindungsgemäßen Verfahrens im Head-End 4 sehr viel mehr verwertbare Daten vor als bisher.

Der im Head-End 4 vorliegende Rohmessdatenstrom 13 besitzt vorzugsweise eine Auflösung im Sekundenbereich, Zehntelsekundenbereich, Hundertstelsekundenbereich oder Tausendstelsekundenbereich.

Gegenstand der Erfindung ist auch, wie in Fig. 1 schematisch dargestellt, ein Versorgungsnetz zur Verteilung eines insbesondere fluiden Verbrauchsguts unter Einsatz einer primären Kommunikationsstrecke 5 sowie entsprechend hergerichtete Verbrauchszähler 10, die in dem Versorgungsnetz betrieben werden. Der jeweilige Verbrauchszähler 10 umfasst, vgl. Fig. 2, mindestens einen Sensor 1, welcher über ein Messelement 9 Rohmessdaten erfassen kann. Des Weiteren umfasst der jeweilige Verbrauchszähler 10 eine Messdatenaufbereitung 14, die einen Mikroprozessor 8, Speichermittel 7 sowie eine Zeitreferenzeinrichtung 15 beinhaltet. In der Messdatenaufbereitung 14 erfolgt eine Zeitstempelung aufgrund der Rohmessdaten, eine Komprimierung der Zeitstempelungen TS sowie eine Aufbereitung in ein Format, das zur Übertragung entlang der primären Kommunikationsstrecke 5 gemäß einem bestimmten Protokoll geeignet ist.

Der Verbrauchszähler 10 umfasst eine (nicht dargestellte) eigene Stromversorgung in Form einer Batterie oder dergleichen.

Im Bereich des Head-Ends 4 sind Auswertemittel 18 vorgesehen, die in der Lage sind, die Zeitstempelungen TS in den einzelnen Datentelegrammen 17ᵢ bis17ᵢ₊ₙ bzw. deren Datenpakete PAⱼ zeitkontinuierlich und ohne Lücken zu einem fortlaufenden lückenlosen Rohmessdatenstrom 13 zusammenzuführen und hieraus entsprechende Dekomprimierungen, Auswertungen, Berechnungen und dergleichen vorzunehmen. Die entsprechenden Daten umfassen vorzugsweise alle in dem Versorgungsnetz befindlichen Verbrauchszähler 10.

Darüber hinaus umfasst das vorgenannte System für das betreffende oder jedes geografische Gebiet, in dem die Verbrauchszähler 10 installiert sind, einen festen Datensammler 3 (Konzentrator), der mit den Verbrauchszählern 10 des Gebietes, das ihm zugewiesen ist, eine primäre Kommunikationsstrecke 5 des Versorgungsnetzes bildet. Die Verbrauchszähler 10 bzw. deren Sensoren 1 sind hierbei die Slaves des Datensammlers 3. Der Datensammler 3 ist wiederum über eine tertiäre Kommunikationsstrecke 6 mit dem Head-End 4 verbunden. Die Daten können entlang der tertiären Kommunikationsstrecke 6 auf unterschiedliche Art und Weise übertragen werden, beispielsweise via LAN, GPRS, LTE, 3G, 4G usw.

Vorzugsweise bilden die Speichermittel 7 eines jeden Sensors 1 bzw. Verbrauchszählers 10 einen Pufferspeicher und sind geeignet und dazu hergerichtet, den Inhalt mehrerer PAⱼ-Pakete von Zeitstempelungen TS insbesondere im komprimierten Zustand zu speichern, wobei der Inhalt oder ein Teil des Inhalts dieses Pufferspeichers bei jeder Übertragung bzw. Abrufs durch den Datensammler 3 übertragen wird.

Die von jedem Datensammler 3 gesammelten Informationen werden direkt oder indirekt an das Head-End 4 übermittelt. Dort werden auch die "Business"-Funktionen definiert und ausgeführt.

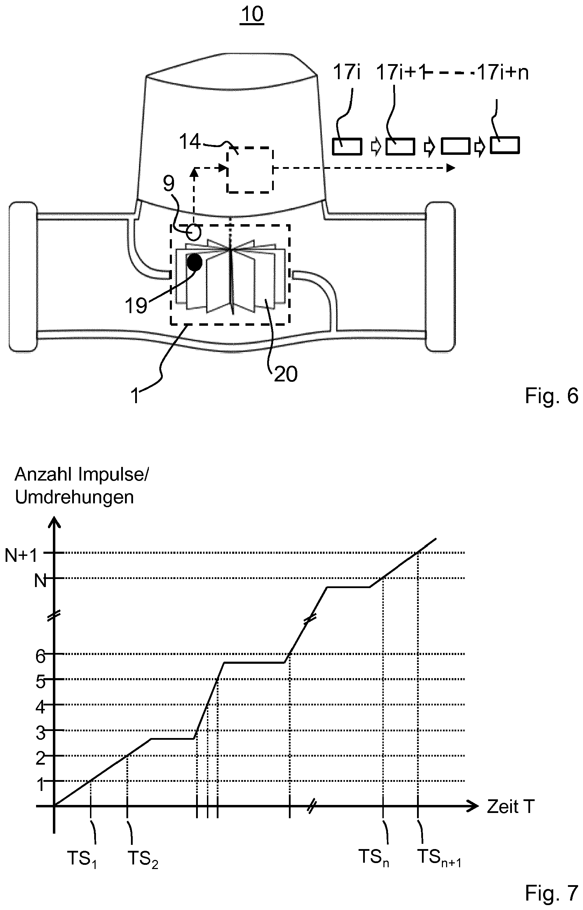

In Fig. 6 ist lediglich beispielhaft ein mechanischer Durchflusszähler 10 mit einem Sensor 1 für den Durchfluss dargestellt. Der Sensor 1 umfasst ein Flügelrad 20, ein Messelements 9 in Form z.B. eines Hallsensors sowie ein Impulsgeberelement 19, welches sich abhängig von dem Durchfluss durch den Durchflusszähler 10 hindurch mehr oder weniger dreht. Die Drehbewegung des Flügelrads 20 wird von dem Messelement 9 als Spannungswert erfasst, der von dem Impulsgeberelement 19 angeregt wird, sofern sich der betreffende Flügel des Flügelrads 20 in der Position des Messelements 9 befindet. Durch das Korrelierungsmodell ist beim Auswerten bekannt, welchem Durchflussvolumen eine Umdrehung entspricht. So kann eine Umdrehung des Flügelrades 20 z.B. einem Liter an Fluid entsprechen.

In der Messwertaufbereitung 14 ist ein Korrelierungsmodell hinterlegt, mit dem die Bedingungen für das Generieren von Zeitstempelungen TS bei bestimmten Rohmesswerten vorher festgelegt sind. Fig. 7 zeigt ein vereinfacht dargestelltes Beispiel eines solchen Korrelierungsmodells z. B. für eine fortlaufende kumulierende Durchflussmessung. Die Messeinheit ist hierbei z. B. ein vom Messelement 9 des in Fig. 6 dargestellten Sensors 1 erfasster Impuls z. B. ein Spannungsimpuls, der einer Umdrehung des Flügelrades 20 entspricht. Die vordefinierte Auflösung des Messverfahrens entspricht daher in diesem Beispiel einer Umdrehung des Flügelrads 20. Die Rohmesswerte, also die durch die Umdrehungen ausgelösten Impulse sowie die zugehörige Zeiten T, werden in den Speichermitteln 7 des Sensors 1 abgespeichert. Die Messwertaufbereitung 14 generiert für jeden Rohmesswert (d. h. für jede Umdrehung/Impuls) eine zugehörige Zeitstempelung TS₁, TS₂......bis TSₙ₊₁. Die Zeitstempelungen TS werden fortlaufend in den Speichermitteln 7 abgelegt. Dreht sich das Flügelrad 20 nicht, wird kein Impuls erzeugt und somit auch keine Zeitstempelung vorgenommen. Dreht sich das Flügelrad 20 langsamer, erfolgt der Zeitpunkt der Erfassung des Impulses entlang der Zeitachse T entsprechend später. Dementsprechend wird in diesem Fall eine spätere Zeitstempelung TS erzeugt. Wie aus Fig. 7 ersichtlich, werden somit eine Vielzahl von Zeitstempelungen TS generiert, die den über die betreffende Zeitspanne kontinuierlich gemessenen Durchfluss definieren.

Die Zeitstempelungen TS werden in Datenpaketen PAⱼ zusammengefasst und gemäß Fig. 2 als Datentelegramme 17ᵢ, 17ᵢ₊₁, 17ᵢ₊ₙ sukzessive nach Aufforderung durch den Datensammler 3 über die primäre Kommunikationsstrecke 5 an diesen übertragen. Die Datenübertragung kann hierbei vorzugsweise in komprimierter Form erfolgen. Es handelt es sich folglich um einen kontinuierlichen lückenlosen Zeitstempelungs-Datenstrom von sehr hoher Auflösung, der in Form der einzelnen fortlaufenden Datentelegramme 17ᵢ, 17ᵢ₊₁, ...., 17ᵢ₊ₙ entlang der primären Kommunikationsstrecke 5 übertragen wird.

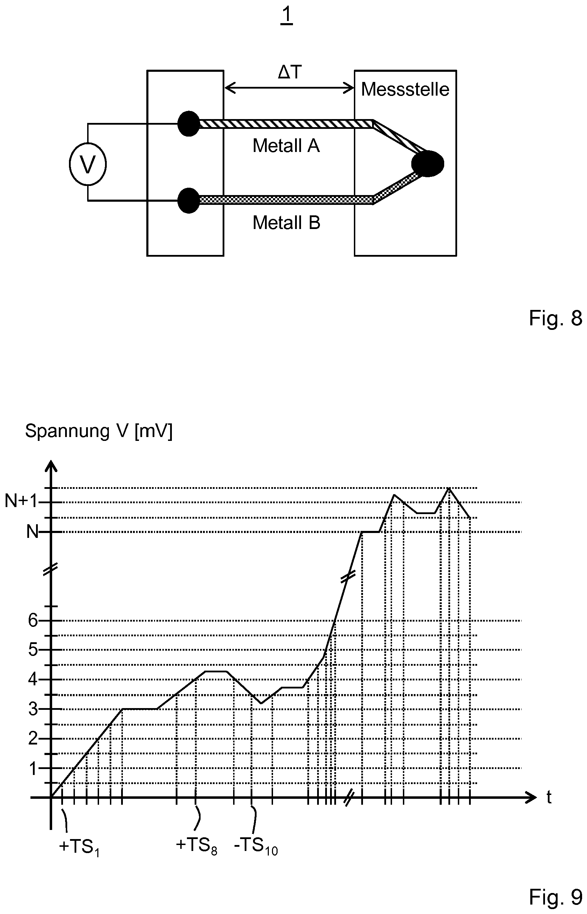

Die Sammlung von Daten ist nicht auf eine Durchflussmessung beschränkt. Fig. 8 zeigt beispielsweise einen Sensor 1 in Form eines auf Widerstandsmessung basierenden Temperaturfühlers. Der Temperaturfühler umfasst zwei im Bereich einer Messstelle miteinander verbundener Metallleiter (A, B) mit unterschiedlicher Wärmeleitfähigkeit. Im Falle eines Temperaturunterschieds ΔT zwischen der Messstelle und dem gegenüberliegenden Ende der beiden Leiter kann eine Spannung V bzw. Spannungsänderung abgegriffen werden. In diesem Fall kann als Korrelierungsmodell eine Zeitstempelung TS für eine Änderung der vom Sensor erfassten Spannung festgelegt werden.

Fig. 9 zeigt ein Beispiel für eine entsprechende Rohmessdatenkurve von Spannungswerten V zur Generierung von entsprechenden Zeitstempelungen TS bei einer Temperaturmessung. Dementsprechend wird bei jedem Anstieg oder Abfall der Spannung z. B. um 0,5 mV eine zugehörige Zeitstempelung TS generiert. Die festgelegte Auflösung des Verfahrens beträgt somit 0,5 mV. Da der Kurvenverlauf bei einer Temperaturmessung aufsteigend sowie abfallend sein kann, werden in diesem Fall die Zeitstempelungen mit einem Vorzeichen "+" für ansteigend oder "-" für abfallend versehen. Wie aus Fig. 9 deutlich wird, erhält man auch hier eine kontinuierliche Abfolge von Zeitstempelungen TS, die den gemessenen Spannungsverlauf und somit die Temperatur über den betrachteten Zeitraum sehr genau und lückenlos abbilden. Ändert sich die Temperatur d. h. die Spannung V nicht, wird keine Zeitstempelung generiert. Im Übrigen entspricht das Verfahren den in Zusammenhang mit dem eingangs beschriebenen Beispiel der Durchflussmessung dargelegten Maßnahmen.

Um die Vollständigkeit und Konsistenz der übertragenen Zeitstempelungen TS zu gewährleisten, werden die Daten vorzugsweise mit Redundanz von dem jeweiligen Verbrauchszähler 10 bzw. Sensor 1 zum Datensammler 3 übertragen. Zweckmäßigerweise kann die Redundanz in der Übertragung durch wiederholtes Senden desselben Datenpakets PAⱼ in mehreren aufeinanderfolgenden Übertragungsvorgängen erreicht werden.

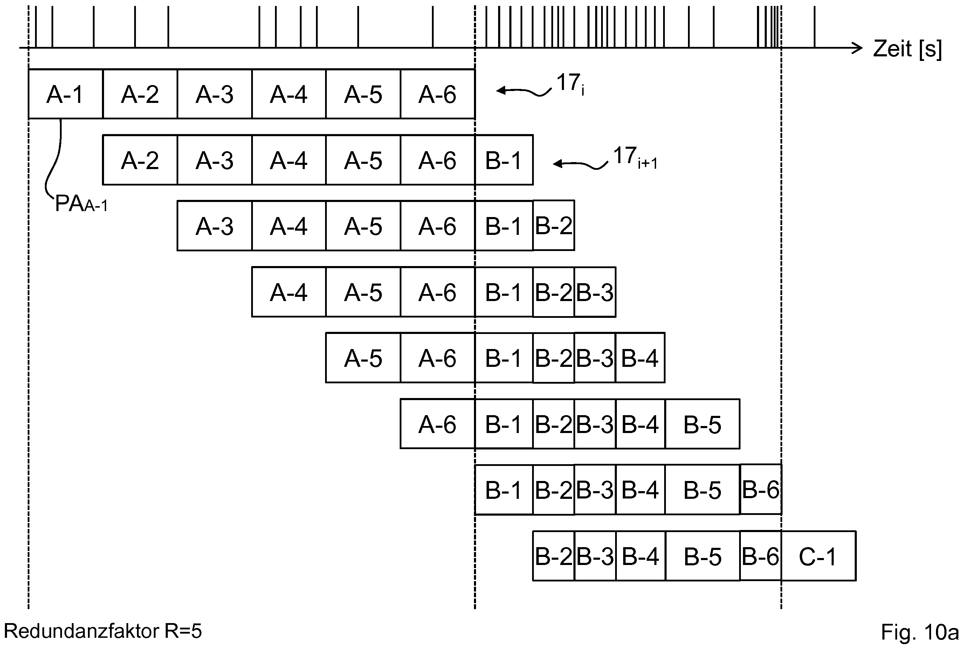

In den Fig. 10a bis 10c ist dargestellt, wie die Redundanz bei der Übertragung durch wiederholte Übertragung desselben PAⱼ-Datenpakets durch mehrere aufeinanderfolgende Übertragungsvorgänge erreicht werden kann. Die Zeitstempelungen TS sind auf der Zeitskala eingezeichnet. Die Zeitstempelungen TS werden durch Formatierung in Datenpakete PAⱼ vorbestimmter fester Größe verpackt. Ein Datenpaket PAⱼ wird übertragen, sobald entweder ein vorgegebenes Zeitintervall abgelaufen ist oder die akkumulierten Zeitstempelungen TS die maximale Größe eines Datenpakets PAⱼ erreichen. In den Fig. 10a bis 10c ist die maximale Größe eines Datenpakets PAⱼ beispielhaft mit fünf Zeitstempelungen TS dargestellt. In Fig. 10a sind in den Datenpaketen PA_{A-1} bis PA_{A-6} sowie in PA_{B-5} und PAc-, weniger als fünf Zeitstempelungen TS enthalten, so dass bei diesen Datenpaketen PAⱼ die Übertragung durch das Ablaufen der vorgegebenen Zeitintervalle ausgelöst wird. Bei den Datenpaketen PA_{B-1} bis PA_{B-4} und PA_{B-6} ist die Übertragung durch das Erreichen der maximalen Größe des Datenpakets PAⱼ ausgelöst worden.

Die Anzahl der letzten gebildeten PAⱼ-Datenpakete, welche in das Datentelegramm 17ᵢ, 17ᵢ₊₁, ...., 17ᵢ₊ₙ mit aufgenommen werden, ist abhängig vom Redundanzfaktor R. So zeigt Fig. 10a einen Redundanzfaktor R=5, so dass neben dem aktuellen bzw. neuesten Datenpaket PA_{A-6} auch die vorherigen fünf Datenpakete A-1 bis A-5 in das Datentelegramm 17ᵢ aufgenommen und übertragen werden. Bei der darauf folgenden Übertragung werden neben dem Datenpaket PA_{B-1} auch die Datenpakete PA_{A-2} bis PA_{A-6} übertragen. Jedes Datenpaket PAⱼ wird somit fünf Mal wiederholt gesendet.

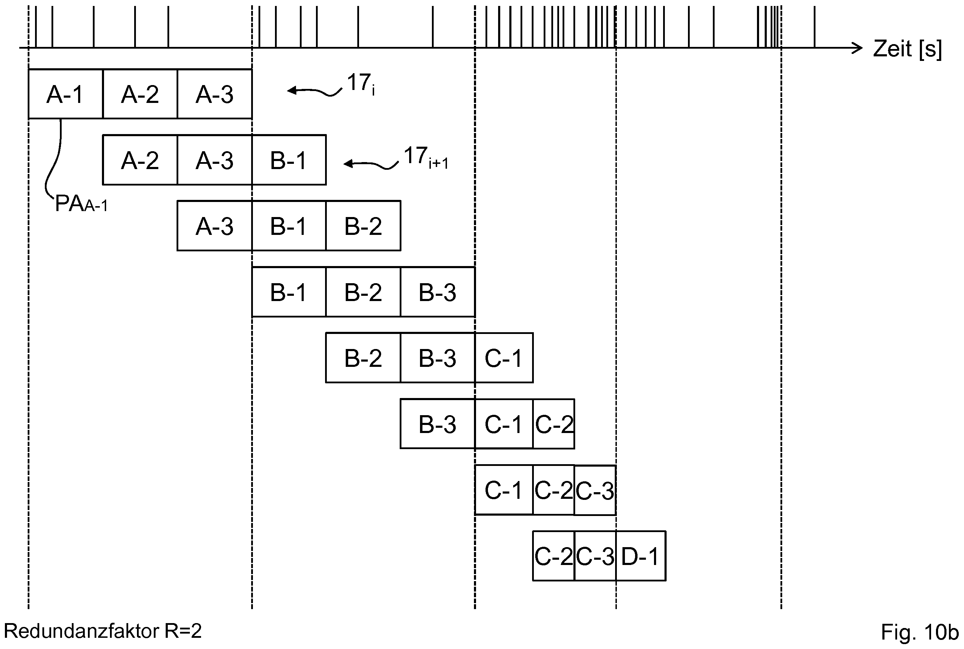

In der in Fig. 10b dargestellten Ausführung ist der Redundanzfaktor auf R=2 gesetzt, so dass jedes Datenpaket PAⱼ zwei Mal wiederholt gesendet wird. Das einzelne Datentelegramm 17ᵢ beinhaltet neben dem neuesten Datenpaket PA_{A-3} auch die vorherigen zwei Datenpakete PA_{A-1} und PA_{A-2}. Das einzelne Datentelegramm 17ᵢ, 17ᵢ₊₁, ...., 17ᵢ₊ₙ beinhaltet damit bei einem Redundanzfaktor R=2 drei Datenpakete PAⱼ, wohingegen das Datentelegramm 17ᵢ, 17ᵢ₊₁, ...., 17ᵢ₊ₙ bei einem Redundanzfaktor R=5, wie in Fig. 10a gezeigt, sechs Datenpakete PAⱼ beinhaltet.

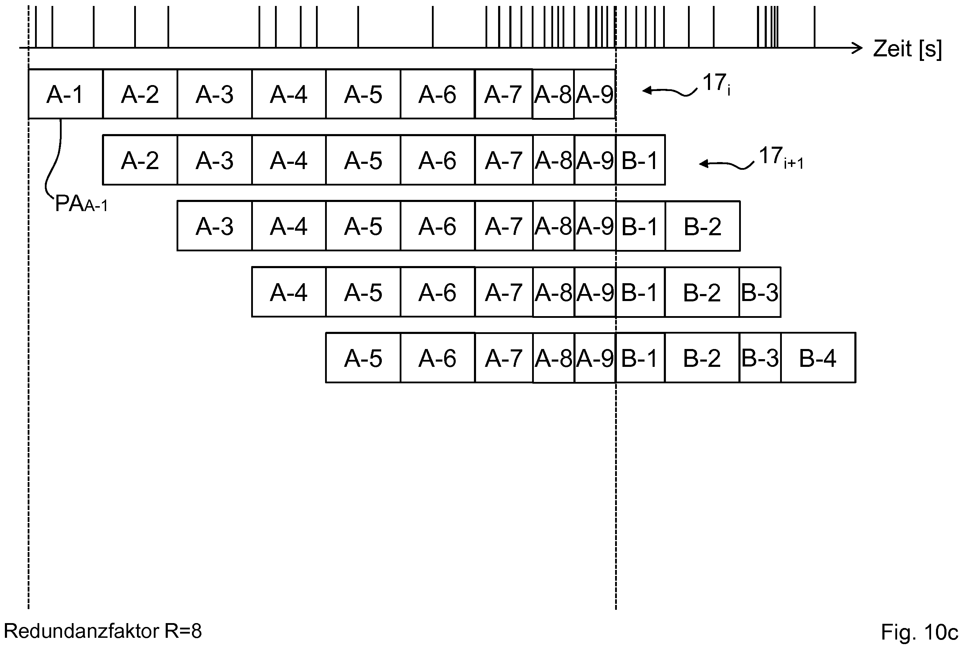

In Fig. 10c ist der Redundanzfaktor auf R=8 gesetzt. Hierbei werden im Datentelegramm 17ᵢ neben dem neuesten bzw. aktuellsten Datenpaket PA_{A-9} auch die letzten Datenpakete PA_{A-1} bis PA_{A-8} übertragen.

Die Redundanz kann über die Einstellung des Redundanzfaktors R dynamisch gesteuert werden. Der Redundanzfaktor R wird durch den Datensammler 3 und/oder durch das Head-End 4 kontrolliert. In einer ersten Ausgestaltung wird die Qualität der Funkverbindung 11, insbesondere der primären Kommunikationsstrecke 5, vom Datensammler 3 und/oder vom Head-End 4 überwacht und analysiert. Zur Analyse der Verbindungsqualität bzw. der Signalqualität wird beispielsweise das Frame Loss Ratio (FLR) oder das signal-to-noise ratio (SNR) oder der Received Signal Strenth Indicator (RSSI) verwendet. Darüber hinaus können auch andere Parameter oder Indikatoren zur Analyse der Qualität der Funkverbindung 11 eingesetzt werden. Entsprechend der ermittelten Verbindungsqualität passt der Datensammler 3 und/oder das Head-End 4 den Redundanzfaktor R des betreffenden Sensors 1 bzw. Verbrauchszählers 10 an. Sofern die Funkverbindung 11 z. B. eine geringe Verlustrate und damit eine gute Verbindungsqualität aufweist, wird der Redundanzfaktor R nach unten gesetzt. Andererseits wird bei einer Funkverbindung 11 mit schlechter Qualität der Redundanzfaktor R für den betreffenden Sensor 1 bzw. Verbrauchszähler 10 erhöht. Da sich die Qualität über die Zeit ändern kann, wird die Verbindungsqualität und damit der Redundanzfaktor R kontinuierlich überwacht und angepasst.

In einer weiteren Ausgestaltung wird die Anzahl der im Datensammler 3 und/oder im Head-End 4 empfangenen redundanten Wiederholungen überwacht und ausgewertet. In Abhängigkeit von der Anzahl an empfangenen Wiederholungen werden Parameter und Einstellungen der Funkverbindung 11 angepasst. Beispielsweise werden die Sensoren 1 bzw. Verbrauchszähler 10 standardmäßig auf den Redundanzfaktor R=5 gesetzt. Sofern alle oder fast alle Wiederholungen, also z. B. 4 bis 5 Wiederholungen, empfangen werden, kann der Datensammler 3 und/oder das Head-End 4 für den entsprechenden Sensor 1 bzw. Verbrauchszähler 10 dessen Sendeleistung reduzieren und/oder dessen Übertragungsintervall vergrößern und/oder dessen Datenrate erhöhen.

Mit dem erfindungsgemäßen Verfahren können somit beliebige Rohmessdaten abgetastet und als Auslöser für Zeitstempelungen TS verwendet werden. Bei den Zeitstempelungen TS kann es sich insbesondere um Zeitpunkte oder Zeitdifferenzen handeln. Vorzugsweise ist ein Startzeitpunkt definiert.

Vorzugsweise werden die Zeitstempelungen TS in den Speichermitteln 7 des Verbrauchszählers 10 erst dann gelöscht, wenn die Übertragung der Zeitstempelungen TS über die primäre Kommunikationsstrecke 5 vom Empfänger bzw. Datensammler 3 bestätigt worden ist.

Der Fachmann versteht selbstverständlich, dass die Erfindung auf die Messung und Fernauslesung verschiedenster Parameter und Größen angewendet werden kann: Es genügt, eine elementare (vom Sensor 1 messbare) Veränderung eines Parameters oder einer Größe in Übereinstimmung mit der Auflösung des betrachteten Sensors 1 genau datieren zu können (die zeitgestempelte elementare Variation kann der Auflösung des Sensors oder möglicherweise einem Vielfachen dieser Auflösung entsprechen).

Selbstverständlich ist die Erfindung nicht auf die in den beigefügten Zeichnungen beschriebenen und dargestellten Ausführungsformen beschränkt. Änderungen bleiben möglich, insbesondere hinsichtlich der Beschaffung der verschiedenen Elemente oder durch technische Entsprechungen, ohne dass dadurch der Schutzbereich der Erfindung verlassen wird, wobei der Schutzbereich der Erfindung durch die folgenden Ansprüche definiert wird. Vom Gegenstand der Offenbarung umfasst, sind ausdrücklich auch Kombinationen von Teilmerkmalen oder Untergruppen von Merkmalen untereinander.

### BEZUGSZEICHENLISTE

- 1: Sensor
- 2: Kommunikationsmittel
- 3: Datensammler
- 4: Head-End
- 5: primäre Kommunikationsstrecke
- 6: tertiäre Kommunikationsstrecke
- 7: Speichermittel
- 8: Mikroprozessor
- 9: Messelement
- 10: Verbrauchszähler
- 11: Funkstrecke
- 13: Rohmessdatenstrom
- 14: Messdatenaufbereitung
- 15: Zeitreferenzeinrichtung
- 16: Versorgungsleitung
- 17: Datentelegramm
- 18: Auswertemittel
- 19: Impulsgeberelement
- 20: Flügelrad

- TS: Zeitstempelung
- R: Redundanzfaktor
- PAⱼ: Datenpaket

## Patentansprüche

1. Verfahren zum Sammeln von Daten in Zusammenhang mit einem Verbrauch, einem physikalischen oder physikalisch-chemischen Parameter und/oder einem Betriebszustand im Rahmen eines Betriebs eines lokalen Sensors (1), vorzugsweise eines Sensors (1) für einen Verbrauchszähler (10), als Bestandteil eines mindestens einen lokalen Sensor (1) vorzugsweise eine Mehrzahl von lokalen Sensoren (1) umfassendes Versorgungsnetzes zur Verteilung eines Verbrauchsguts, wobei
der Sensor (1) ein Messelement (9) enthält,
das Messelement (9) des jeweiligen Sensors (1) elementare Messeinheiten, die mindestens einer physikalischen oder physikalisch-chemischen Größe oder mindestens eines physikalischen oder physikalisch-chemischen Parameters entsprechen, als Rohmessdaten liefert, und
der Sensor (1) Kommunikationsmittel (2) sowie Speichermittel (7) umfasst, wobei
zur Festlegung der Messauflösung des Sensors (1) die Bedingungen für ein Generieren von Zeitstempelungen (TS) unter Anwendung eines Korrelierungsmodells vorher festgelegt werden,
auf der Basis des Korrelierungsmodells Zeitstempelungen (TS) von aufeinanderfolgenden Rohmessdaten in dem Sensor (1) generiert werden,
die Zeitstempelungen (TS) übertragen werden, so dass auf Basis der Zeitstempelungen (TS) unter Anwendung des Korrelierungsmodells die vom Messelement (9) erfassten Rohmessdaten rekonstruiert und ausgewertet werden, und wobei
der Sensor (1) über eine primäre Kommunikationsstrecke (5) mit einem Datensammler (3) in Verbindung steht,
zwischen dem Datensammler (3) und einem Head-End (4) eine tertiäre Kommunikationsstrecke (6) vorgesehen ist, und
die von dem Sensor (1) übertragenen Zeitstempelungen (TS) im Datensammler (3) und/oder im Head-End (4) gesammelt, gespeichert und/oder ausgewertet werden, **dadurch gekennzeichnet, dass**
die Übertragung mit einer während des Betriebs dynamisch anpassbaren Redundanz durchgeführt wird, wobei die Redundanz in der Übertragung durch wiederholtes Senden derselben Zeitstempelungen (TS) und/oder wiederholtes Senden desselben Datenpakets (PAⱼ) in mehreren aufeinanderfolgenden Übertragungsvorgängen erreicht wird und
eine Mehrzahl von Zeitstempelungen (TS) entlang der primären Kommunikationsstrecke (5) jeweils als Datenpaket (17ᵢ, 17ᵢ₊ₙ) übertragen werden, wobei ein Datenpaket jeweils mehrere Zeitstempelungen (TS1-TSn) enthält, und
die Festlegung, wann eine Datenübertragung vom Sensor (1) durchzuführen ist, davon abhängt, ob eine vorgegebene Menge an insbesondere komprimierten gesammelten Zeitstempelungen (TS) seit der vorherigen Datenübertragung erreicht ist.

2. Verfahren nach Anspruch 1, **dadurch gekennzeichnet, dass** die Zeitstempelungen (TS) in komprimierter Form übertragen werden, wobei insbesondere vorgesehen ist, **dass** die Zeitstempelungen (TS) komprimiert werden und die Komprimierung der Zeitstempelungen verlustfrei durchgeführt wird oder die Komprimierung der Zeitstempelungen (TS) mit einem vorgegebenen zulässigen Verlustniveau durchgeführt wird.

3. Verfahren nach einem der vorhergehenden Ansprüche, **dadurch gekennzeichnet, dass** im Rahmen des Korrelierungsmodells ein bestimmter Wert, eine bestimmte Wertänderung oder eine bestimmte Wertdifferenz der mindestens einen physikalischen oder physikalisch-chemischen Größe oder des mindestens einen physikalischen oder physikalisch-chemischen Parameters für die Zuordnung einer Zeitstempelung (TS) festgelegt wird, bei einem Erfassen des bestimmten Werts, der bestimmten Wertänderung oder der bestimmten Wertdifferenz durch das Messelement (9) eine Zeitstempelung (TS) ausgelöst und in den Speichermitteln (7) des Sensors (1) abgespeichert wird.

4. Verfahren nach einem der vorhergehenden Ansprüche, **dadurch gekennzeichnet, dass** im Rahmen des Korrelierungsmodells ein schrittweise oder inkrementell sich erhöhender Zählerstand und/oder eine Wertetabelle mittels Zeitstempelungen (TS) abgebildet wird.

5. Verfahren nach einem der vorhergehenden Ansprüche, **dadurch gekennzeichnet, dass** die Zeitstempelungen (TS) mit einem Vorzeichen versehen sind.

6. Verfahren nach einem der vorhergehenden Ansprüche, **dadurch gekennzeichnet, dass** auf Basis der beim Datensammler (3) und/oder beim Head-End (4) ankommenden Zeitstempelungen (TS) unter Anwendung des Korrelierungsmodells ein Rohmessdatenstrom (13) generiert wird, wobei der Rohmessdatenstrom (13) insbesondere eine zeitliche Auflösung besitzt, die durch die Sensor-Abtastrate bzw. Messelement-Abtastrate oder ein Vielfaches derselben festgelegt oder bedingt ist.

7. Verfahren nach einem der vorhergehenden Ansprüche, **dadurch gekennzeichnet, dass** der Rohmessdatenstrom (13) unter Zugrundelegung einer stetigen zeitlichen Auflösung kontinuierlich und/oder vollständig ist, wobei insbesondere vorgesehen ist, **dass** der Rohmessdatenstrom (13) in der Weiterfolge der Datenverarbeitung abgesehen von der Messauflösung des Sensors (1) auf einer zeithistorischen Basis zeitlückenlos auswertbar ist.

8. Verfahren nach einem der vorhergehenden Ansprüche, **dadurch gekennzeichnet, dass** es sich bei den elementaren Messeinheiten um die elektrische Spannung oder um die Stromstärke handelt.

9. Verfahren nach einem der vorhergehenden Ansprüche, **dadurch gekennzeichnet, dass** die gemessene physikalische Größe sich auf ein Versorgungsmedium, vorzugsweise Wasser, Strom, Treibstoff oder Gas, eines Versorgungsnetzes bezieht und/oder der oder einer der gemessene(n) physikalische(n) oder chemisch-physikalische(n) Parameter kennzeichnend ist für die Menge, die Qualität und/oder Zusammensetzung eines Fluids, das durch den betreffenden Sensor (1) strömt oder von diesem kontaktiert wird.

10. Verfahren nach einem der vorhergehenden Ansprüche, **dadurch gekennzeichnet, dass** die elementare Messeinheit (9) eine Zeitstempelung (TS) generiert, sobald die elementare Messeinheit (9) einen Impuls empfängt.

11. Verfahren nach einem der vorhergehenden Ansprüche, **dadurch gekennzeichnet, dass** die Festlegung, wann eine neue Datenübertragung in Form einer Nachricht oder eines Telegramms durchzuführen ist, vom
Ablauf eines vorgegebenen Zeitintervalls abhängt.

12. Verfahren nach einem der vorhergehenden Ansprüche, **dadurch gekennzeichnet, dass** es umfasst, die Zeitstempelungen (TS) durch Formatierung in Datenpaketen (PAⱼ) vorbestimmter fester Größe zu verpacken, wobei jedes Mal, wenn die akkumulierten Daten die Größe eines Datenpakets (PAⱼ) erreichen oder das vorgegebene Zeitintervall abgelaufen ist, eine neue Übertragung ausgelöst wird.

13. Verfahren nach einem der vorhergehenden Ansprüche, **dadurch gekennzeichnet, dass** die Anzahl der Sende-Wiederholungen durch einen Redundanzfaktor (R) festgelegt wird, wobei insbesondere vorgesehen ist, **dass** der Redundanzfaktor (R) dynamisch durch einen Datensammler (3) und/oder ein Head-End (4) festgelegt wird und/oder der Redundanzfaktor (R) in Abhängigkeit der Qualität der Funkverbindung dynamisch festgelegt wird.

14. Verfahren nach einem der vorhergehenden Ansprüche, **dadurch gekennzeichnet, dass** in Abhängigkeit der Anzahl der empfangenen Wiederholungen aufgrund der Redundanz, Eigenschaften oder Parameter der Funkverbindung angepasst werden.

15. Sensor (1) zum Sammeln von Daten in Zusammenhang mit einem Verbrauch, einem physikalischen oder physikalisch-chemischen Parameter und/oder einem Betriebszustand im Rahmen, vorzugsweise für einen Verbrauchszähler (10), als Bestandteil eines mindestens einen lokalen Sensor (1) vorzugsweise eine Mehrzahl von lokalen Sensoren (1) umfassendes Versorgungsnetzes zur Verteilung eines Verbrauchsguts, wobei
der Sensor (1) ein Messelement (9) enthält,
das Messelement (9) des jeweiligen Sensors (1) elementare Messeinheiten, die mindestens einer physikalischen oder physikalisch-chemischen Größe oder mindestens eines physikalischen oder physikalisch-chemischen Parameters entsprechen, als Rohmessdaten liefert,
der Sensor (1) Kommunikationsmittel (2) sowie Speichermittel (7) umfasst, wobei der Sensor (1) dazu eingerichtet ist,
zur Festlegung der Messauflösung des Sensors (1) die Bedingungen für ein Generieren von Zeitstempelungen (TS) unter Anwendung eines Korrelierungsmodells vorher festzulegen,
auf der Basis des Korrelierungsmodells Zeitstempelungen (TS) von aufeinanderfolgenden Rohmessdaten in dem Sensor (1) zu generieren,
die Zeitstempelungen (TS) über eine drahtgebundene Verbindung und/ oder über eine Funkstrecke zu übertragen, wobei
der Sensor (1) über eine primäre Kommunikationsstrecke (5) mit einem über eine tertiäre Kommunikationsstrecke (6) verbindbaren Datensammler (3) verbindbar ist, **dadurch gekennzeichnet, dass**
der Sensor (1) dazu eingerichtet ist,
die Übertragung mit einer während des Betriebs dynamisch anpassbaren Redundanz durchzuführen, wobei die Redundanz in der Übertragung durch wiederholtes Senden derselben Zeitstempelungen (TS) und/oder wiederholtes Senden desselben Datenpakets (PAⱼ) in mehreren aufeinanderfolgenden Übertragungsvorgängen erreicht wird und
eine Mehrzahl von Zeitstempelungen (TS) entlang der primären Kommunikationsstrecke (5) jeweils als Datenpaket (17ᵢ, 17ᵢ₊ₙ) zu übertragen, wobei ein Datenpaket jeweils mehrere Zeitstempelungen(TS1-TSn) enthält und
die Festlegung, wann eine Datenübertragung durchzuführen ist, davon abhängig zu machen, ob eine vorgegebene Menge an insbesondere komprimierten gesammelten Zeitstempelungen (TS) seit der vorherigen Datenübertragung erreicht ist.

16. Versorgungsnetz zur Verteilung eines Verbrauchsmediums mit
mindestens einem lokalen Sensor (1) vorzugsweise einer Mehrzahl von lokalen Sensoren (1) zum Generieren und/oder Weiterleiten von Rohmessdaten, vorzugsweise Rohmessdaten in Zusammenhang mit einem Verbrauch an Verbrauchsmedium, einem physikalischen oder physikalisch-chemischen Parameter und/oder einem Betriebszustand eines Verbrauchszählers (10),
einem Datensammler (3),
einer primären Kommunikationsstrecke (5) zwischen dem jeweiligen Sensor (1) und dem Datensammler (3),
einem Head-End (4) zur Auswertung der Daten, sowie einer tertiären Kommunikationsstrecke (6) zwischen Datensammler (3) und Head-End (4), **dadurch gekennzeichnet, dass** als lokaler Sensor ein Sensor (1) nach Anspruch 15 vorgesehen ist.

## Claims

1. Method for collecting data, associated with a consumption, a physical or physical/chemical parameter and/or an operating status during operation of a local sensor (1), preferably a sensor (1) for a consumption meter (10), as a component of a supply network for distributing a consumable, which supply network comprises at least one local sensor (1), preferably a plurality of local sensors (1), wherein
the sensor (1) contains a measuring element (9),
the measuring element (9) of the respective sensor (1) supplies, as raw measurement data, elementary measurement units, which correspond to at least one physical or physical/chemical variable or at least one physical or physical/chemical parameter, and
the sensor (1) comprises communication means (2) and storage means (7), wherein
in order to define the measurement resolution of the sensor (1), the conditions for generating time stamps (TS) are defined in advance using a correlation model,
time stamps (TS) of successive items of raw measurement data are generated in the sensor (1) on the basis of the correlation model,
the time stamps (TS) are transmitted so that the raw measurement data acquired by the measuring element (9) is reconstructed using the correlation model on the basis of the time stamps (TS), and analysed, and wherein
the sensor (1) is connected to a data collector (3) via a primary communication path (5),
a tertiary communication path (6) is provided between the data collector (3) and a head-end (4), and
the time stamps (TS) transmitted by the sensor (1) are collected, saved and/or analysed in the data collector (3) and/or in the head-end (4), **characterized in that**
the transmission is carried out with a redundancy that can be dynamically adapted during operation, wherein the redundancy in the transmission is achieved by repeatedly transmitting the same time stamps (TS) and/or repeatedly transmitting the same data packet (PAⱼ) in a plurality of successive transmission operations, and
a plurality of time stamps (TS) are transmitted as one data packet (17ᵢ, 17ᵢ₊ₙ) along the primary communication path (5), wherein a data packet respectively contains a plurality of time stamps (TS1-TSn), and
the stipulation of when a data transmission should be carried out by the sensor (1) depends on whether a specified amount of, in particular compressed, collected time stamps (TS) since the previous data transmission has been reached.

2. Method according to Claim 1, **characterized in that** the time stamps (TS) are transmitted in compressed form, wherein provision is made, in particular, **for** the time stamps (TS) to be compressed and for the compression of the time stamps to be carried out in a loss-free manner or for the compression of the time stamps (TS) to be carried out with a predefined permissible loss level.

3. Method according to one of the preceding claims, **characterized in that** a specific value, a specific change in value or a specific difference in value of the at least one physical or physical/chemical variable or of the at least one physical or physical/chemical parameter is defined within the correlation model for the purpose of assigning a time stamp (TS),
when the measuring element (9) detects the specific value, the specific change in value or the specific difference in value, a time stamp (TS) is actuated and saved in the storage means (7) of the sensor (1).

4. Method according to one of the preceding claims, **characterized in that** a meter reading that increases in steps or incrementally and/or a value table is/are modelled within the correlation model using time stamps (TS) .

5. Method according to one of the preceding claims, **characterized in that** the time stamps (TS) are given a sign.

6. Method according to one of the preceding claims, **characterized in that** a raw measurement-data stream (13) is generated using the correlation model on the basis of the time stamps (TS) received at the data collector (3) and/or the head-end (4), wherein the raw measurement-data stream (13) has, in particular, a temporal resolution which is defined or conditioned by the sensor sampling rate or measuring element sampling rate or a multiple thereof.

7. Method according to one of the preceding claims, **characterized in that** the raw measurement-data stream (13) is continuous and/or complete taking a continuous temporal resolution as a basis, wherein provision is made, in particular, for the raw measurement-data stream (13) to be able to be analysed in the further course of the data processing on a time-historical basis with no time gaps, aside from the measurement resolution of the sensor (1).

8. Method according to one of the preceding claims, **characterized in that** the elementary measurement units are the voltage or the current.

9. Method according to one of the preceding claims, **characterized in that** the measured physical variable relates to a supply medium, preferably water, electricity, fuel or gas, of a supply network, and/or the, or one of the, measured physical or chemical/physical parameter(s) is an indicator of the volume, quality and/or composition of a fluid that is flowing through, or makes contact with, the sensor (1) concerned.

10. Method according to one of the preceding claims, **characterized in that** the elementary measurement unit (9) generates a time stamp (TS) as soon as the elementary measurement unit (9) receives a pulse.

11. Method according to one of the preceding claims, **characterized in that** the stipulation of when a new data transmission should be carried out in the form of a message or telegram depends on the expiry of a predefined interval of time.

12. Method according to one of the preceding claims, **characterized in that** it comprises packaging the time stamps (TS) by formatting them in data packets (PAⱼ) of a predetermined fixed size, wherein, each time the accumulated data reach the size of a data packet (PAⱼ) or the predefined interval of time has expired, a new transmission is initiated.

13. Method according to one of the preceding claims, **characterized in that** the number of repeated transmissions is defined by a redundancy factor (R), wherein provision is made, in particular, **for** the redundancy factor (R) to be dynamically defined by a data collector (3) and/or a head-end (4) and/or for the redundancy factor (R) to be dynamically defined on the basis of the quality of the radio connection.

14. Method according to one of the preceding claims, **characterized in that** properties or parameters of the radio connection are adapted on the basis of the number of received repetitions on account of the redundancy.

15. Sensor (1) for collecting data, associated with a consumption, a physical or physical/chemical parameter and/or an operating status, preferably for a consumption meter (10), as a component of a supply network for distributing a consumable, which supply network comprises at least one local sensor (1), preferably a plurality of local sensors (1), wherein
the sensor (1) contains a measuring element (9),
the measuring element (9) of the respective sensor (1) supplies, as raw measurement data, elementary measurement units, which correspond to at least one physical or physical/chemical variable or at least one physical or physical/chemical parameter,
the sensor (1) comprises communication means (2) and storage means (7), wherein the sensor (1) is configured
in order to define the measurement resolution of the sensor (1), to define the conditions for generating time stamps (TS) in advance using a correlation model,
to generate time stamps (TS) of successive items of raw measurement data in the sensor (1) on the basis of the correlation model,
to transmit the time stamps (TS) via a wired connection and/or a radio path, wherein
the sensor (1) can be connected to a data collector (3), which can be connected via a tertiary communication path (6), via a primary communication path (5), **characterized in that**
the sensor (1) is configured
to carry out the transmission with a redundancy that can be dynamically adapted during operation, wherein the redundancy in the transmission is achieved by repeatedly transmitting the same time stamps (TS) and/or repeatedly transmitting the same data packet (PAⱼ) in a plurality of successive transmission operations, and
to transmit a plurality of time stamps (TS) as one data packet (17ᵢ, 17ᵢ₊ₙ) along the primary communication path (5), wherein a data packet respectively contains a plurality of time stamps (TS1-TSn),
to make the stipulation of when a data transmission should be carried out dependent on whether a specified amount of, in particular compressed, collected time stamps (TS) since the previous data transmission has been reached.

16. Supply network for distributing a consumption medium, comprising
at least one local sensor (1), preferably a plurality of local sensors (1), for generating and/or transferring raw measurement data, preferably raw measurement data associated with a consumption of consumption medium, a physical or physical/chemical parameter and/or an operating status of a consumption meter (10),
a data collector (3),
a primary communication path (5) between the respective sensor (1) and the data collector (3),
a head-end (4) for analysing the data, and
a tertiary communication path (6) between data collector (3) and head-end (4), **characterized in that** a sensor (1) according to Claim 15 is provided as local sensor.

## Revendications

1. Procédé permettant de collecter des données liées à une consommation, à paramètre physique ou physico-chimique et/ou à un état de fonctionnement dans le cadre d'un fonctionnement d'un capteur local (1), de préférence d'un capteur (1) pour un compteur de consommation (10), en tant que composant d'un réseau d'alimentation comprenant au moins un capteur local (1), de préférence une pluralité de capteurs locaux (1), pour distribuer un produit de consommation, dans lequel
le capteur (1) comporte un élément de mesure (9),
l'élément de mesure (9) du capteur respectif (1) fournit en tant que données de mesure brutes des unités de mesure élémentaires qui correspondent à au moins une grandeur physique ou physico-chimique ou à au moins un paramètre physique ou physico-chimique, et
le capteur (1) comprend des moyens de communication (2) ainsi que des moyens de stockage (7), dans lequel
pour définir la résolution de mesure du capteur (1), les conditions de génération d'horodatages (TS) sont définies au préalable en appliquant un modèle de corrélation,
des horodatage (TS) de données de mesure brutes consécutives sont générés dans le capteur (1) sur la base du modèle de corrélation,
les horodatages (TS) sont transmis de sorte que sur la base des horodatages (TS) en appliquant le modèle de corrélation, les données de mesure brutes détectées par l'élément de mesure (9) soient reconstituées et évaluées, et dans lequel
le capteur (1) est en communication avec un collecteur de données (3) par l'intermédiaire d'une voie de communication primaire (5),
une voie de communication tertiaire (6) est prévue entre le collecteur de données (3) et une tête de réseau (4), et
les horodatages (TS) transmis par le capteur (1) sont collectés, stockés et/ou évalués dans le collecteur de données (3) et/ou dans la tête de réseau (4),
**caractérisé en ce que**
la transmission est effectuée avec une redondance adaptable de manière dynamique en cours de fonctionnement, dans lequel la redondance de la transmission est obtenue par un envoi répété des mêmes horodatages (TS) et/ou par un envoi répété du même paquet de données (PAⱼ) dans plusieurs opérations de transmission consécutives, et
une pluralité d'horodatages (TS) est transmise le long de la voie de communication primaire (5) respectivement sous forme de paquet de données (17ᵢ, 17ᵢ₊ₙ) , un paquet de données contenant respectivement plusieurs horodatages (TS1 à TSn), et
la définition quand une transmission de données est à effectuer par le capteur (1) dépend du fait si une quantité prédéfinie d'horodatages (TS) collectés, en particulier comprimés, soit atteinte depuis la transmission de données précédente.

2. Procédé selon la revendication 1, **caractérisé en ce que** les horodatages (TS) sont transmis sous forme comprimée, dans lequel il est prévu en particulier que les horodatages (TS) soient comprimés et que la compression des horodatages soit effectuée sans perte ou que la compression des horodatages (TS) soit effectuée avec un niveau de perte admissible prédéfini.

3. Procédé selon l'une quelconque des revendications précédentes, **caractérisé en ce que** dans le cadre du modèle de corrélation, une valeur déterminée, une variation de valeur déterminée ou une différence de valeur déterminée de ladite au moins une grandeur physique ou physico-chimique ou dudit au moins un paramètre physique ou physico-chimique est définie pour l'attribution d'un horodatage (TS), lors d'une détection de la valeur déterminée, de la variation de valeur déterminée ou de la différence de valeur déterminée par l'élément de mesure (9), un horodatage (TS) étant déclenché et stocké dans les moyens de stockage (7) du capteur (1).

4. Procédé selon l'une quelconque des revendications précédentes, **caractérisé en ce que** dans le cadre du modèle de corrélation, une position de compteur augmentant progressivement ou par incréments et/ou une table de valeurs est/sont représentée(s) au moyen d'horodatages (TS).

5. Procédé selon l'une quelconque des revendications précédentes, **caractérisé en ce que** les horodatages (TS) sont signés.

6. Procédé selon l'une quelconque des revendications précédentes, **caractérisé en ce qu'**un flux de données de mesure brutes (13) est généré sur la base des horodatages (TS) arrivant au collecteur de données (3) et/ou à la tête de réseau (4), en appliquant le modèle de corrélation, dans lequel le flux de données de mesure brutes (13) possède une résolution, en particulier temporelle, qui est définie ou impliquée par le taux d'échantillonnage du capteur ou le taux d'échantillonnage de l'élément de mesure ou un multiple de ceux-ci.

7. Procédé selon l'une quelconque des revendications précédentes, **caractérisé en ce que** le flux de données de mesure brutes (13) est continu et/ou complet en partant du principe d'une résolution temporelle constante, dans lequel il est prévu en particulier que le flux de données de mesure brutes (13) dans la suite du traitement de données, mise à part la résolution de mesure du capteur (1), puisse être évalué sans interruption sur une base d'un historique de temps.

8. Procédé selon l'une quelconque des revendications précédentes, **caractérisé en ce que** les unités de mesure élémentaires sont la tension électrique ou l'intensité de courant.

9. Procédé selon l'une quelconque des revendications précédentes, **caractérisé en ce que** la grandeur physique mesurée se réfère à un milieu d'alimentation, de préférence de l'eau, du courant, du carburant ou du gaz, d'un réseau d'alimentation et/ou **en ce que** le ou l'un des paramètres physiques ou chimio-physiques mesurés caractérisent la quantité, la qualité et/ou la composition d'un fluide qui traverse le capteur (1) en question ou entre en contact avec celui-ci.

10. Procédé selon l'une quelconque des revendications précédentes, **caractérisé en ce que** l'unité de mesure élémentaire (9) génère un horodatage (TS) dès que l'unité de mesure élémentaire (9) reçoit une impulsion.

11. Procédé selon l'une quelconque des revendications précédentes, **caractérisé en ce que** la définition quand une nouvelle transmission de données est à effectuer sous la forme d'un message ou d'un télégramme dépend du déroulement d'un intervalle de temps prédéfini.

12. Procédé selon l'une quelconque des revendications précédentes, **caractérisé en ce qu'**il comprend le regroupement des horodatages (TS) par formatage dans des paquets de données (PAⱼ) d'une taille fixe prédéterminée, dans lequel une nouvelle transmission est déclenchée chaque fois que les données accumulées atteignent la taille d'un paquet de données (PAⱼ) ou l'intervalle de temps prédéfini est écoulé.

13. Procédé selon l'une quelconque des revendications précédentes, **caractérisé en ce que** le nombre des répétitions d'envoi est défini par un facteur de redondance (R), dans lequel il est prévu en particulier que le facteur de redondance (R) soit défini de manière dynamique par un collecteur de données (3) et/ou une tête de réseau (4) et/ou que le facteur de redondance (R) soit défini de manière dynamique en fonction de la qualité de la liaison radio.

14. Procédé selon l'une quelconque des revendications précédentes, **caractérisé en ce que** des propriétés ou des paramètres de la liaison radio sont adaptés en fonction du nombre des répétitions reçues en raison de la redondance.

15. Capteur (1) permettant de collecter des données liées à une consommation, à un paramètre physique ou physico-chimique et/ou à un état de fonctionnement, de préférence pour un compteur de consommation (10) en tant que composant d'un réseau d'alimentation comprenant au moins un capteur local (1), de préférence d'une pluralité de capteurs locaux (1), pour distribuer un produit de consommation, dans lequel
le capteur (1) comporte un élément de mesure (9),
l'élément de mesure (9) du capteur respectif (1) fournit en tant que données de mesure brutes des unités de mesure élémentaires qui correspondent à au moins une grandeur physique ou physico-chimique ou à au moins un paramètre physique ou physico-chimique,
le capteur (1) comprend des moyens de communication (2) ainsi que des moyens de stockage (7), le capteur (1) étant conçu pour
définir au préalable les conditions de génération d'horodatages (TS) en appliquant un modèle de corrélation pour définir la résolution de mesure du capteur (1),
générer des horodatage (TS) de données de mesure brutes consécutives dans le capteur (1) sur la base du modèle de corrélation,
transmettre les horodatages (TS) par une liaison filaire et/ou par une voie radio, dans lequel
le capteur (1) peut être relié par une voie de communication primaire (5) à un collecteur de données (3) pouvant être relié par une voie de communication tertiaire (6),
**caractérisé en ce que**
le capteur (1) est conçu pour
effectuer la transmission avec une redondance pouvant être adaptée de manière dynamique en cours de fonctionnement, dans lequel la redondance de la transmission est obtenue par un envoi répété des mêmes horodatages (TS) et/ou par un envoi répété du même paquet de données (PAⱼ) dans plusieurs opérations de transmission consécutives, et
transmettre une pluralité d'horodatages (TS) le long de la voie de communication primaire (5) respectivement sous forme de paquet de données (17ᵢ, 17ᵢ₊ₙ), un paquet de données contenant respectivement plusieurs horodatages (TS1 à TSn), et
faire que la définition quand une transmission de données est à effectuer dépende du fait si une quantité prédéfinie d'horodatages (TS) collectés, en particulier comprimés, soit atteinte depuis la transmission de données précédente.

16. Réseau d'alimentation permettant de distribuer un milieu de consommation, comprenant
au moins un capteur local (1), de préférence une pluralité de capteurs locaux (1), pour générer et/ou retransmettre des données de mesure brutes, de préférence des données de mesure brutes liées à une consommation d'un milieu de consommation, à un paramètre physique ou physico-chimique et/ou à un état de fonctionnement d'un compteur de consommation (10),
un collecteur de données (3),
une voie de communication primaire (5) entre le capteur respectif (1) et le collecteur de données (3),
une tête de réseau (4) pour évaluer les données, et
une voie de communication tertiaire (6) entre le collecteur de données (3) et la tête de réseau (4),
**caractérisé en ce qu'**un capteur (1) selon la revendication 15 est prévu en tant que capteur local.
